# FASCICULE DE BREVET EUROPEEN

(11) **EP 1 948 720 B1**
(45) Date de publication et mention de la délivrance du brevet: **30.03.2011**
(21) Numéro de dépôt: 06820167.2
(22) Date de dépôt: 09.10.2006
(51) Int. Cl.: C08J 7/12, H01L 21/30

(54) **UTILISATION D'UN SEL DE DIAZONIUM DANS UN PROCEDE DE MODIFICATION DE SURFACES ISOLANTES OU SEMI-CONDUCTRICES, ET PRODUITS AINSI OBTENUS**
VERWENDUNG EINES DIAZONIUMSALZS IN EINEM VERFAHREN ZUR MODIFIZIERUNG VON ISOLIERENDEN ODER HALBLEITENDEN OBERFLÄCHEN UND RESULTIERENDE PRODUKTE
USE OF A DIAZONIUM SALT IN A METHOD FOR MODIFYING INSULATING OR SEMI-CONDUCTIVE SURFACES, AND RESULTING PRODUCTS

(30) Priorité: 26.10.2005 FR 0510914
(43) Date de publication de la demande: 30.07.2008
(73) Titulaire: Alchimer, 91300 Massy (FR)
(72) Inventeur: BUREAU, Christophe, F-91260 Juvisy sur Orge (FR); PINSON, Jean, F-94120 Fontenay-sous-Bois (FR)
(74) Mandataire: Grosset-Fournier, Chantal Catherine
(86) Numéro de dépôt international: PCT/FR2006/002260
(87) Numéro de publication internationale: WO 2007/048894

(56) Documents cités:
- WO-A-2006/000692
- FR-A- 2 672 307
- FR-A- 2 761 377
- FR-A- 2 829 046
- US-A1- 2002 197 467

## Description

La présente invention a pour objet un procédé de modification de surfaces isolantes ou semi-conductrices ou de composés binaires ou ternaires, notamment par le greffage d'un groupe aromatique provenant d'un sel de diazonium portant ledit groupe aromatique, ainsi que les produits tels qu'obtenus.

L'électrogreffage permet la fonctionnalisation de surfaces conductrices de l'électricité. Un des avantages considérables de l'électrogreffage est que l'énergie qui permet à la fois la formation des liaisons d'interface et la croissance des films est apportée au niveau de la surface : c'est donc la surface elle-même qui est génératrice de sa propre fonctionnalisation. Cette propriété a, par exemple, pour conséquence que les couches électrogreffées épousent avec grande précision la topologie des surfaces sur lesquelles elles ont été réalisées, et ce même à des échelles nanométriques. A l'échelle macroscopique, elle a également pour conséquence que l'électrogreffage permet des revêtements sur des pièces ayant une forme de complexité arbitraire avec la même qualité partout : partout où la surface de la pièce est en contact avec la solution d'électrogreffage, il y a formation d'un film électrogreffé.

Il est évidemment impossible de réaliser l'électrogreffage sur des surfaces d'isolants, tout au moins sous sa forme habituelle, étant donné que l'activation d'un isolant est impossible par voie électrique.

Dans le but de proposer des fonctionnalisations de qualité analogue sur tout type de surfaces, il est nécessaire de mettre au point des procédés de greffage sur isolants, en cherchant - soit dans les précurseurs moléculaires, soit dans les techniques d'activation des surfaces - des spécificités qui permettent de conserver les éléments essentiels constatés pour l'électrogreffage : liaison d'interface (covalente ou non), conformité, homogénéité...

L'electrogreffage (*e*G™) des sels de diazonium effectué sur carbone (Pinson J., Podvorica F., Chem Soc. Rev , 2005, 34, 429 ; Allongue P., Delamar M., Desbat B., Fagebaume O., Hitmi R., Pinson J., Savéant J.M., J. Am. Chem. Soc., 1997, 119, 201 ; Liu Y. C., McCreery R. L., J. Am. Chem. Soc., 1995, 117, 11254 ; Saby C., Ortiz B., Champagne G. Y., Bélanger D., Langmuir, 1997, 13, 6803), sur métal (Adenier A., Bernard M.-C., Chehimi M. M., Deliry E., Desbat B., Fagebaume O., Pinson J., Podvorica F., J. Am. Chem. Soc., 2001, 123, 4541 ; Bernard M. C., Chaussé A., Cabet-Deliry E., Chehimi M. M., Pinson J., Podvorica F., Vautrin-U1 C., Chem. Mat. 2003, 15, 3450 ; Marwan J., Addou T., Belanger D., Chem. Mater., 2005; 17; 2395) et sur semi-conducteurs (Henry de Villeneuve C., Pinson J., Allongue P., J. Phys Chem., 1997, 101, 2415) n'est applicable qu'à des surfaces conductrices ou semi-conductrices. Le greffage spontané ou thermique (c'est-à-dire sans induction électrochimique ou photochimique) de groupes aryles sur la surface de carbone a déjà été mis en évidence (Demandes internationales WO 96/18688, WO 96/18690, WO 96/18674, WO 96/18695, WO 97/47692, WO 97/47698, WO 98/34960, WO 99/07794, WO 99 23,174, WO 0053681 ; et Brevets US 5 672 198, US 5 713 988, US 5 698 016, US 5 851 280, US 5 885 355, US 6 110 994).

La simple introduction de noir de carbone dans une solution de sel de diazonium permet de modifier la surface du carbone par attachement des groupes aryles provenant du sel de diazonium. Cette réaction de greffage spontané a été étendue à des métaux et des semi-conducteurs, notamment le silicium (Bahr J. L. et Tour J. M., Chem. Mater., 2001, 13, 3823 ; Bahr J. L., Yang J., Kosynkin D. V., Bronikowski M. J., Smalley R. E., Tour J. M., J. Am. Chem. Soc., 2001, 123, 6536 ; Dyke C. A., Tour J. M., J. Am. Chem. Soc., 2003, 125, 1156 ; Dyke C. A., Tour J. M., Nano Letters, 2003, 3, 1215 ; Strano M. C., Dyke C. A., Ursa M. L., Barone P. W., Allen M. J., Shan H., Kittrell C., Hauge R. H., Tour J. M., Smalley R. E., Science, 2003, 301, 1519 ; Fan F.-R., Yang J., Lintao C., Price D. W., Dirk S. M., Kosynkin D. V., Yao Y., Rawlett A. M., Tour J. M., Bard A. J., J. Am. Chem. Soc., 2002, 124, 5550 ; Demande de brevet aux Etats-Unis publiée le 5 février 2004 sous le numéro US 2004/0023479A1 ; Adenier A., Cabet-Deliry E., Chaussé A., Griveau S., Mercier F., Pinson J., Vautrin-Ul C., Chem. Mat., 2005, 17, 491 ; Hurley B. L., McCreery R. L., J. Electrochem. Soc., 2004, 15, B252-B259).

Cependant, il a été observé que ce greffage spontané se produisait car l'objet, conducteur ou semi-conducteur est, à son potentiel de circuit ouvert (potentiel qu'il adopte spontanément lorsqu'il est plongé seul dans la solution contenant le sel de diazonium), suffisamment réducteur pour réduire spontanément les sels de diazonium, selon le même mécanisme que celui observé lors de la réduction électrochimique. Le greffage spontané des sels de diazonium sur les surfaces est donc un cas particulier du greffage électrochimique, et ne se fait donc que pour certains matériaux, qui ont un potentiel de circuit ouvert suffisamment cathodique dans un bain de sel de diazonium. Pour ces matériaux, le greffage par voie électrochimique, et non seulement spontané, ne fait qu'accélérer la réaction de greffage qui se produit de toute façon sans sollicitation électrochimique.

De ce point de vue, on observe d'ailleurs que les vitesses de réaction de greffage spontané des sels de diazonium sur les surfaces à leur potentiel de circuit ouvert sont lentes : une heure voire davantage pour pouvoir obtenir un taux de couverture maximal sur la surface.

Il serait cependant tout à fait intéressant de pouvoir modifier de la même façon des isolants tels que les polymères organiques ou les surfaces d'oxydes, ce qui permettrait de modifier leur surface en leur conférant des propriétés spécifiques tout en gardant les propriétés mécaniques et électriques du matériau.

Le brevet US 6,555,175 concerne un procédé pour traiter des matières polymériques comprenant l'utilisation d'un sel de diazonium. Plus précisément, ce procédé concerne la décomposition thermique de solutions concentrées de sels de diazonium formés in situ à partir d'amines amphiphiles sur des polymères aromatiques. Ce procédé ne comprend pas l'utilisation de réducteurs mais nécessite une étape de chauffage à 70°C des réactifs. De plus, le temps de réaction est d'environ 8 heures, ce qui pose problème, dans la mesure où la décomposition du sel de diazonium a lieu dans un temps court.

La présente invention a pour but de fournir un procédé de greffage d'isolants par des groupements aryles issus de sels de diazonium.

La présente invention a pour but de fournir un procédé de modification de surfaces isolantes ou semi-conductrices ou de composés binaires ou ternaires, comprenant la mise en oeuvre de réactions de greffage des groupements aryles dont les cinétiques sont nettement plus rapides que celles des procédés actuels.

La présente invention a également pour but de fournir un procédé de modification de substrats très résistifs, en particulier semi-conducteurs très résistifs ou de composés binaires ou ternaires très résistifs, à l'instar de ce qui est obtenu par sollicitation électrochimique, mais sans avoir les inconvénients liés aux effets de chute ohmique par exemple.

La présente invention a également pour but de fournir des surfaces de matériaux composites comprenant au moins deux des matériaux choisis parmi les surfaces isolantes, les surfaces semi-conductrices et les composés binaires ou ternaires.

La présente invention concerne l'utilisation d'un sel de diazonium R-N₂⁺ portant un groupe aromatique R, pour le greffage dudit groupe aromatique sur des surfaces isolantes, semi-conductrices ou de composés binaires ou ternaires ou de matériaux composites, lesdites surfaces présentant une résistivité supérieure ou égale à 10⁻⁵ Ω.m, et de préférence supérieure ou égale à 10⁻³ Ω.m, ledit sel de diazonium étant présent à une concentration supérieure à 0,05 M, et variant de préférence d'environ 0,5 M à environ 4 M, et notamment à une concentration proche de sa limite de solubilité dans les conditions de l'expérience (solvant et température).

Selon un mode de réalisation avantageux, le sel de diazonium est présent à une concentration supérieure à 0,1 M.

On précise que l'on entend par "groupe aromatique R", un radical dérivé d'un composé cyclique comportant un ou plusieurs noyaux benzéniques indépendants ou condensés, et/ou un ou plusieurs noyaux complexes dérivés du benzène. Ce radical peut bien entendu comporter aussi des noyaux hétérocycliques et/ou divers substituants ainsi que des chaînes hydrocarbonées comportant éventuellement des hétéroatomes tels que N, O et S.

L'expression "surfaces isolantes" désigne la surface d'un matériau qui ne permet pas le déplacement d'électrons ou de trous et dont la résistivité est de l'ordre d'au moins 10¹⁰ Ω.m. Par exemple, les polymères qui sont des isolants ont des résistivités de l'ordre de 10¹³ à 10¹⁵ Ω.m ; ainsi, pour le polyéthylène utilisé ici, la résistivité est de l'ordre de 10¹³ Ω.m et celle du polypropylène est de l'ordre de 10¹⁴ Ω.m.

L'expression "surfaces semi-conductrices" désigne la surface d'un matériau semi-conducteur, c'est-à-dire d'un matériau dans lequel le courant est transporté par des électrons et des trous et dont la conductibilité électrique, lorsqu'il est très pur, croît exponentiellement avec la température et peut être accrue de plusieurs ordres de grandeur à partir de sa valeur intrinsèque par dopage avec des impuretés électriquement actives. Les semi-conducteurs sont caractérisés par la valeur de la bande interdite qui sépare la bande de valence de la bande de conduction (L. I. Berger, B. R. Pamplin, Handbook of Chemistry and Physics, 84th edition, CRC Press; Boca Raton, p. 12-97). Par exemple, la résistivité théorique du silicium intrinsèque est de l'ordre de 3 Ω.m et dépend de sa pureté. En ce qui concerne les matériaux utilisés couramment en microélectronique, le dopage se situe entre 10¹⁵ et 10¹⁹ atomes/cm² et la résistivité dépend ensuite du type de dopant (bore pour le dopage p ; arsenic, phosphore ou antimoine pour le dopage n). Ainsi, le silicium avec un dopage n par de l'arsenic (10¹⁵ atomes/cm²) a une résistivité de 3.10⁻² Ω.m ; le silicium avec un dopage n par de l'arsenic (10¹⁹ atomes/cm²) a une résistivité de 4,4.10⁻⁵ Ω.m ; le silicium avec un dopage p par du bore (10¹⁵ atomes/cm²) a une résistivité de 9.10⁻² Ω.m et le silicium avec un dopage p par du bore (10¹⁹ atomes/cm²) a une résistivité de 9.10⁻⁵ Ω.m.

L'expression "composés binaires ou ternaires" désigne des composés binaires ou ternaires présentant différentes phases, par exemple Ta, TaNₓ, TaSiₓN_{y}, TiNₓ, TaSiₓN_{y}, WNₓ, WCₓN_{y} et WSiₓN_{y}. Ces composés largement utilisés dans l'industrie de la microélectronique, en particulier dans le procédé connu sous le nom de procédé Damascène lequel a été décrit par exemple dans Chang, C.Y. et Sze, S. M., 1996, "ULSI Technology" Mc Graw-Hill, New York. Ces composés sont déposés en couche mince par différentes méthodes telles que la PVD ("Physical Vapor Deposition" : dépôt physique en phase vapeur), CVD ("Chemical Vapor Deposition" : dépôt chimique en phase vapeur) ou ALD ("Atomic Layer Deposition" : dépôt par couche atomique). Ces composés sont par exemple décrits dans les références suivantes : Kim, S-H.; Suk S.; Kim, H-M; Kang, D-H; Kim, K-B.; Li, W-M; Suvi, H.; Tuominen, M. J.Electrochem Soc., 2004, 151, C272-C282 et H.B. Nie1, S.Y.Xu , S.J. Wang, L.P.You1, Z.Yang, , C.K.Ong, J. Li, T.Y.F. Liew, Appl. Phys. A, 2001, 73, 229-236.

Les couches minces susmentionnées servent notamment de barrière de diffusion ou de migration du cuivre ou d'électrodes pour les couches magnétiques de stockage de l'information ou de matériau de grille pour les transistors CMOS (Complementary Metal Oxide Semiconductors). La résistivité électrique de ces couches minces dépend très fortement des conditions de dépôt et s'étend sur une gamme allant de 2.10⁻³ Ω.m jusqu'à 2.10⁻¹ Ω.m. Aux valeurs les plus élevées de la résistivité de ces couches minces, les procédés de greffage électrochimique deviennent inefficaces à cause de la chute ohmique dans le matériau. Par exemple les couches barrières de ces matériaux utilisés dans le procédé Damascène ont une résistance trop élevée pour permettre, par voie électrochimique un dépôt de cuivre homogène à l'échelle de la plaquette.

L'expression "matériaux composites" désigne des matériaux composites comprenant au moins deux des matériaux choisis parmi les surfaces isolantes, les surfaces semi-conductrices et les composés binaires ou ternaires tels que définis ci-dessus, étant entendu que lesdits matériaux composites sont des composites en surface. Parmi ces matériaux composites, on peut citer par exemple des surfaces de silice comprenant des tranchées remplies de cuivre (applications en microélectronique), des surfaces comprenant en partie un diélectrique tel que la silice et un composé binaire tel que TiN ou TaN, des surfaces de polymère organique comprenant certaines parties métalliques ou des prothèses de hanches dont la surface est composée de titane et de céramique. On peut également envisager d'avoir un matériau composite comprenant deux matériaux de même catégorie, par exemple un matériau comprenant deux isolants différents ou comprenant deux semi-conducteurs différents.

L'expression "concentration du sel de diazonium proche de sa limite de solubilité" désigne la concentration à partir de laquelle, à une température donnée et dans un solvant donné, le sel de diazonium précipite.

On cherche à avoir la concentration maximale de sel de diazonium, de telle façon à ce que lorsqu'on ajoute un réducteur ou lorsqu'on soumet à des ultrasons, on produise le maximum de radicaux aryles dont la majeure partie sera perdue dans des réactions en solution, mais dont une plus faible partie attaquera la surface. Dans le cadre du procédé de l'invention, on ne peut aller au-delà de la limite de solubilité.

Si la concentration du sel de diazonium est trop faible compte tenu de la réactivité du radical et est donc trop éloignée de la limite de solubilité dudit sel, la réaction de greffage ne sera pas suffisamment efficace et le rendement de cette réaction sera très faible.

Les liaisons formées sur les polymères sont des liaisons C_{aliphatique ou aromatique}-C_{aromatique} dont l'énergie est de l'ordre de 400 kJ par mole.

Le greffage électrochimique a été attribué à la formation de radicaux aryles après transfert d'un électron au sel de diazonium. La présente invention repose sur la formation homogène de radicaux aryles en solution homogène soit à l'aide d'un réducteur, soit par photochimie d'un complexe de transfert de charge, soit par activation par des ultrasons. Dans ces derniers cas, les radicaux aryles ne sont pas formés à la surface de l'électrode qu'on souhaite modifier comme dans le cas des réductions électrochimiques, ils sont produits au sein de la solution et la plus grande partie d'entre eux réagit avec les composants de la solution. Seule une faible partie de ces radicaux aryles réagit avec la surface pour conduire au greffage de celle-ci. Il est donc nécessaire, comme indiqué dans la présente demande, d'utiliser des concentrations élevées de sel de diazonium pour obtenir des concentrations suffisantes de radicaux aryles aptes à se greffer à la surface.

La présente invention concerne également l'utilisation telle que définie ci-dessus dans laquelle le groupe aromatique greffé provient de la réduction dudit sel de diazonium, notamment
- par l'utilisation d'un réducteur dudit sel de diazonium,
- par l'irradiation photochimique d'un complexe de transfert de charges formé à partir dudit sel de diazonium ou
- par le traitement dudit sel de diazonium par ultrasons.

Le greffage d'un groupe aromatique sur des surfaces isolantes ou des surfaces semi-conductrices ou sur des surfaces de composés binaires ou ternaires ou sur des surfaces de matériaux composites permet l'obtention de surfaces isolantes ou semi-conductrices modifiées ou de surfaces modifiées de composés binaires ou ternaires ou de surfaces modifiées de matériaux composites, c'est-à-dire des surfaces sur lesquelles est greffé ledit groupe aromatique.

L'expression "réduction du sel de diazonium" désigne ici la réaction conduisant au radical aryle et au diazote par le transfert formel d'un électron :

Ar-N⁺≡N + "1e⁻" → Ar° + N₂

L'expression "complexe de transfert de charges" ou "complexe donneur-accepteur" désigne un complexe, c'est-à-dire l'association de deux espèces chimiques et en particulier de deux molécules, où ces deux espèces échangent au moins en partie un doublet d'électrons ; la molécule donneur fournit soit une paire d'électrons non liants (n) ou d'électrons π à une molécule accepteur déficiente en électrons, ici le sel de diazonium. Ces complexes de transfert de charge se caractérisent en général par leur spectre UV-visible différent de la somme des spectres des molécules donneur et accepteur (J. March, Advanced Organic Chemistry, 4° edition, John Wiley, New York, p.79).

L'expression "irradiation photochimique d'un complexe de transfert de charges formé à partir du sel de diazonium" désigne l'irradiation par de la lumière visible ou ultraviolette (de préférence ultraviolette) d'une solution contenant une molécule accepteur, le sel de diazonium et une molécule donneur, susceptibles de former un complexe de transfert de charge.

L'expression "traitement du sel de diazonium par ultrasons" désigne le procédé qui consiste à soumettre une solution de sel de diazonium à des ultrasons.

En réduisant avec un réducteur homogène, qui est un réducteur dissous dans la même phase que le sel de diazonium, une solution suffisamment concentrée de sel de diazonium, on crée une grande quantité de radicaux aryles. Une partie des radicaux produits de manière homogène dans la solution réagit avec une surface plongeant dans la solution. Ceci permet donc de modifier la surface de polymères organiques et plus généralement d'isolants par des radicaux aryles, notamment par arrachement d'atomes d'hydrogène et couplage de radicaux, par addition S_{H} sur des aromatiques (Kochi, J. K. Free Radicals vol 1 et 2 : New York, 1973) ou par addition de type Merweein (Dombrovski Russian Chem. Rev. 1984, 53, 943 ; Rondestvedt Org. React. 1976, 24, 225) sur des doubles liaisons. Il est également possible de faire réagir lesdits radicaux avec les substrats de la microélectronique tels que SiO₂.

De même, en irradiant le complexe de transfert de charge, on favorise le transfert d'électrons dans ce complexe et la formation des radicaux aryles.

De même, en soumettant la solution de sel de diazonium à des ultrasons, on favorise la réduction du sel de diazonium et la formation du radical aryle correspondant.

La présente invention concerne également un procédé de modification de la surface d'un matériau isolant, d'un matériau semi-conducteur, d'un composé binaire ou ternaire ou d'un matériau composite, pour obtenir un matériau isolant, un matériau semi-conducteur, un composé binaire ou ternaire ou un matériau composite dont la surface est modifiée par greffage de groupes aromatiques sur ladite surface, éventuellement substitués par des groupes fonctionnels, dans lequel la nature de la liaison entre la surface et les groupes aromatiques greffés qui la modifient est une liaison de type covalent, et étant notamment telle qu'elle résiste à un lavage par ultrasons,

ledit procédé comprenant la mise en contact de ladite surface avec un sel de diazonium et la réduction dudit sel de diazonium portant ledit groupe aromatique à une concentration proche de sa limite de solubilité, à une concentration supérieure à 0,05 M, et variant de préférence d'environ 0,5 M à environ 4 M, notamment une concentration proche de sa limite de solubilité, notamment par l'utilisation d'un réducteur, par l'irradiation photochimique d'un complexe de transfert de charges formé à partir dudit sel de diazonium ou par le traitement dudit sel de diazonium par ultrasons, pour obtenir lesdits groupes aromatiques greffés sur ladite surface.

Selon un mode de réalisation avantageux, le sel de diazonium est présent à une concentration supérieure à 0,1 M.

L'expression "groupes fonctionnels" désigne des substituants du groupe aryle greffé, susceptibles de réagir avec des molécules ou capables de présenter des propriétés particulières.

Selon le procédé de la présente invention, la surface est modifiée de telle sorte que ledit procédé entraîne la formation de liaisons entre la surface et les groupes aromatiques greffés correspondant à des liaisons covalentes entre un atome de carbone dudit groupe aromatique et un atome de ladite surface.

Selon un mode de réalisation préféré, le procédé de l'invention est caractérisé en ce que la durée de la mise en présence de la surface et du sel de diazonium réduit est inférieure à environ 60 minutes, et notamment dure environ 1 à 60 minutes, et de préférence environ 1 à 10 minutes.

Selon un mode de réalisation préféré, le procédé de l'invention est caractérisé en ce que la durée de la mise en présence de la surface et du sel de diazonium réduit par l'utilisation d'un réducteur ou par l'irradiation photochimique d'un complexe de transfert de charges dure environ 1 à 10 minutes.

Selon un mode de réalisation préféré, le procédé de l'invention est caractérisé en ce que la durée de la mise en présence de la surface et du sel de diazonium réduit par l'utilisation d'ultrasons dure environ 10 à 60 minutes et de préférence 20 minutes.

Selon un mode de réalisation avantageux, le procédé de l'invention est caractérisé en ce que le sel de diazonium répond à la formule ArN₂⁺ X⁻, dans laquelle Ar représente le groupe aromatique et X représente un anion avantageusement choisi parmi : les halogènes, les sulfates, les phosphates, les perchlorates, les tétrafluoroborates, les carboxylates et les hexafluorophosphates.

L'anion peut être un substituant du groupe aryle par exemple un groupe sulfonate, on obtient alors une molécule amphiphile comportant un sel de diazonium.

La présente invention concerne également un procédé tel que défini ci-dessus, caractérisé en ce que le groupe aromatique est un reste aromatique en C₆-C₁₄, éventuellement substitué par un ou plusieurs substituants fonctionnels ou un reste hétéroaromatique de 4 à 14 atomes, éventuellement substitué par un ou plusieurs substituants fonctionnels, comportant un ou plusieurs hétéroatomes choisis parmi l'oxygène, l'azote, le soufre ou le phosphore.

La présente invention concerne également un procédé tel que défini ci-dessus, caractérisé en ce que le groupe aromatique comporte un ou plusieurs substituants choisis dans le groupe constitué par :
- les radicaux aliphatiques, linéaires ou ramifiés de 1 à 20 atomes de carbone, comportant éventuellement une ou plusieurs double(s) ou triple(s) liaison(s), éventuellement substitués par des radicaux carboxyles, NO₂, amino protégé disubstitué, amino monosubstitué protégé, cyano, diazonium, alkoxy de 1 à 20 atomes de carbone, alkoxycarbonyle de 1 à 20.atomes de carbones, alkylcarbonyloxy de 1 à 20 atomes de carbone, vinyle éventuellement fluoré ou allyle, les atomes d'halogène,
- les radicaux aryles éventuellement substitués par des radicaux carboxyles, NO₂, amino protégé disubstitué, amino monosubstitué protégé, cyano, diazonium, alkoxy de 1 à 20 atomes de carbone, alkoxycarbonyle de 1 à 20 atomes de carbone, alkylcarbonyloxy de 1 à 20 atomes de carbone, vinyle éventuellement fluoré ou allyle, les atomes d'halogène,
- les radicaux carboxyles, NO₂, amino protégé disubstitué, amino monosubstitué protégé, amido, cyano, diazonium, sulfoniques, phosphoniques, alkoxy de 1 à 20 atomes de carbone, alkoxycarbonyle de 1 à 20 atomes de carbone, alkylcarbonyloxy de 1 à 20 atomes de carbone, vinyle éventuellement fluoré, les atomes d'halogène.

Selon un mode de réalisation avantageux, le procédé de l'invention est caractérisé en ce que le groupe aromatique comporte un ou plusieurs substituants susceptibles de réagir directement avec des résines organiques, des molécules biologiques, des molécules chimiques ou des agents complexants, où un ou plusieurs substituants précurseurs qui, après transformation, sont susceptibles de réagir avec des résines organiques, des molécules biologiques, des molécules chimiques ou des agents complexants.

L'expression "substituants susceptibles de réagir directement avec des polymères, des molécules chimiques ou biologiques" désigne les substituants du groupe aromatique fixé sur la surface et possédant des fonctions réactives susceptibles de réagir avec les fonctions chimiques portées par d'autres molécules. Les exemples de fonctions réactives portées par le groupe aromatique sont les fonctions allyliques ou vinyliques ou acétyléniques, les halogènes, les alcools, par exemple de type -(CH₂)ₙ-CH₂-OH, les acides carboxyliques, par exemple de type -(CH₂)ₙ-COOH, les anhydrides ou halogénures d'acide, les nitriles, les isocyanates, les amines, par exemple de type -(CH₂)ₙ-NH₂, n étant un nombre entier variant de 0 à 10, les acides sulfoniques ou les sulfonates, les acides phosphoniques ou les phosphonates.

L'expression "substituants précurseurs qui, après transformation, sont susceptibles de réagir avec des polymères, des molécules chimiques ou biologiques" désigne des substituants qui après une ou plusieurs transformations sont susceptibles de réagir avec des polymères, des molécules chimiques ou biologiques. Les substituants précurseurs qui, après transformation, sont susceptibles de réagir sont, par exemple, NO₂, N₂⁺, (CH₂)ₙ-CN, (CH₂)ₙ-CHO, (CH₂)ₙ-COOPr, Pr étant un groupe protecteur, -(CH₂)ₙ-NHP'ᵣ, (CH₂)ₙ-N(P'ᵣ)₂, (CH₂)ₙ-N=P"ᵣ, P'ᵣ, P"ᵣ étant des groupes protecteurs, n étant un nombre entier variant de 1 à 10. Le chlorure de phénacyle sulfonyle ou le chlorure d'acétyle sont des exemples de groupes protecteurs des amines.

L'expression "résine organique" désigne des polymères portant des fonctions réactives par exemple les polymères styrène-co-divinylbenzène fonctionnalisés (aminométhyl polystyrène, bromopolystyrène, hydroxyméthyl polystyrène) utilisés dans la synthèse combinatoire, les polymères utilisés dans la synthèse peptidique (par exemple la résine de Wang : polystyrène portant des fonctions alkoxybenzylalcool).

L'expression "molécule biologique" désigne une molécule intervenant dans les systèmes biologiques comme des enzymes ou des antigènes.

L'expression "molécule chimique" désigne toutes les molécules comportant des fonctions susceptibles de réagir avec le groupe aryle fonctionnalisé : groupes allyliques ou vinyliques ou acétyléniques, des halogènes, des alcools, par exemple de type -(CH₂)ₙ-CH₂-OH, des acides carboxyliques par exemple de type -(CH₂)ₙ-COOH, des anhydrides ou halogénures d'acide, des nitriles, des isocyanates, des amines par exemple de type -(CH₂)ₙ-NH₂, n étant un nombre entier variant de 0 à 10, des acides sulfoniques ou des sulfonates, des acides phosphoniques ou des phosphonates, ou des fonctions susceptibles de réagir après transformation avec une résine organique et choisis dans le groupe constitué par NO₂, N₂⁺, (CH₂)ₙ-CN, (CH₂)ₙ-CHO, (CH₂)ₙ-COOPᵣ, Pᵣ étant un groupe protecteur, -(CH₂)ₙ-NHP'ᵣ, (CH₂)ₙ-N(P'ᵣ)₂, (CH₂)ₙ-N=P"ᵣ, P'ᵣ, P"ᵣ étant des groupes protecteurs, n étant un nombre entier compris variant de 1 à 10. Le chlorure de phénacyle sulfonyle ou le chlorure d'acétyle sont des exemples de groupes protecteurs des amines.

L'expression "agent complexant" désigne une molécule susceptible de complexer par exemple des ions métalliques. On peut notamment citer l'EDTA (acide éthylènediaminetétracétique), l'amino-8 quinoléine, les éthers couronne, les cryptates et la phénylalanine.

La présente invention concerne également un procédé tel que défini ci-dessus, caractérisé en ce que le groupe aromatique comporte un ou plusieurs substituants susceptibles de réagir directement avec une résine organique et choisis dans le groupe constitué par des groupements allyliques ou vinyliques ou acétyléniques, des halogènes, des alcools par exemple de type -(CH₂)ₙ-CH₂-OH, des acides carboxyliques par exemple de type -(CH₂)ₙ-COOH, des anhydrides ou halogénures d'acide, des nitriles, des isocyanates, des amines par exemple de type -(CH₂)ₙ-NH₂, n étant un nombre entier variant de 0 à 10, des acides sulfoniques ou des sulfonates, des acides phosphoniques ou des phosphonates, ou un ou plusieurs substituants précurseurs susceptibles de réagir après transformation avec une résine organique et choisis dans le groupe constitué par NO₂, N₂⁺, (CH₂)ₙ-CN, (CH₂)ₙ-CHO, (CH₂)ₙ-COOPᵣ, Pᵣ étant un groupe protecteur, -(CH₂)ₙ-NHP'ᵣ, (CH₂)ₙ-N(P'ᵣ)₂, (CH₂)ₙ-N=P"ᵣ, P'ᵣ, P"ᵣ étant des groupes protecteurs, n étant un nombre entier variant de 1 à 10. Le chlorure de phénacylsulfonyle ou le chlorure d'acétyle sont des exemples de groupes protecteurs des amines.

Un procédé préféré selon la présente invention est un procédé tel que défini ci-dessus, caractérisé en ce que le groupe aromatique comporte un ou plusieurs substituants susceptibles de réagir directement avec une molécule biologique et choisis dans le groupe des fonctions allyliques ou vinyliques ou acétyléniques, des halogènes, des alcools par exemple de type -(CH₂)ₙ-CH₂-OH, des acides carboxyliques par exemple de type -(CH₂)ₙ-COOH, des anhydrides ou halogénures d'acide, des nitriles, des isocyanates, des amines par exemple de type -(CH₂)ₙ-NH₂, n étant un nombre entier variant de 0 à 10, des acides sulfoniques ou des sulfonates, des acides phosphoniques ou des phosphonates, ou un ou plusieurs substituants précurseurs susceptibles de réagir après transformation avec une résine organique et choisis dans le groupe constitué par NO₂, N₂⁺, (CH₂)ₙ-CN, (CH₂)ₙ-CHO, (CH₂)ₙ-COOPᵣ, Pᵣ étant un groupe protecteur, -(CH₂)ₙ-NHP'ᵣ, (CH₂)ₙ-N(P'ᵣ)₂, (CH₂)ₙ-N=P"ᵣ, P'ᵣ, P"ᵣ étant des groupes protecteurs, n étant un nombre entier variant de 1 à 10. Le chlorure de phénacylsulfonyle ou le chlorure d'acétyle sont des exemples de groupes protecteurs des amines.

Selon un mode de réalisation avantageux, le procédé de l'invention est caractérisé en ce que le groupe aromatique comporte un ou plusieurs substituants susceptibles de réagir directement avec des molécules organiques fonctionnelles et choisis dans le groupe des fonctions allyliques ou vinyliques ou acétyléniques, des halogènes, des alcools par exemple de type -(CH₂)ₙ-CH₂-OH, des acides carboxyliques par exemple de type -(CH₂)ₙ-COOH, des anhydrides ou halogénures d'acide, des nitriles, des isocyanates, des amines par exemple de type -(CH₂)ₙ-NH₂, n étant un nombre entier variant de 0 à 10, des acides sulfoniques ou des sulfonates, des acides phosphoniques ou des phosphonates, ou un ou plusieurs substituants précurseurs susceptibles de réagir après transformation avec une résine organique et choisis dans le groupe constitué par NO₂, N₂⁺, (CH₂)ₙ-CN, (CH₂)ₙ-CHO, (CH₂)ₙ-COOPᵣ, Pᵣ étant un groupe protecteur, -(CH₂)ₙ-NHP'ᵣ, (CH₂)ₙ-N(P'ᵣ)₂, (CH₂)ₙ-N=P"ᵣ, P'ᵣ, P"ᵣ étant des groupes protecteurs, n étant un nombre entier variant de 1 à 10. Le chlorure de phénacylsulfonyle ou le chlorure d'acétyle sont des exemples de groupes protecteurs des amines.

La présente invention concerne également un procédé tel que défini ci-dessus, caractérisé en ce que le sel de diazonium est choisi parmi :

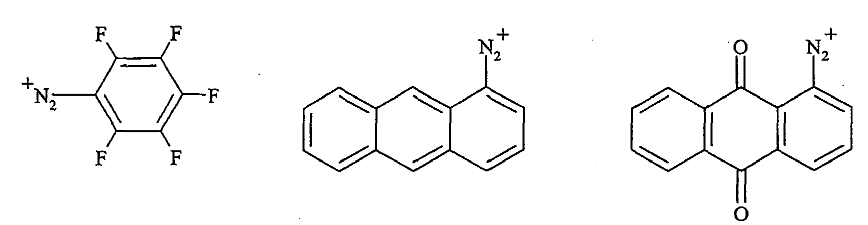

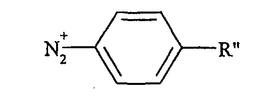

R" étant choisi parmi les groupes suivants : -CH₃, *n*-C₄H₉, *n*-C₁₂H₂₅, -OC₁₂H₂₅, -OC₁₆H₃₃, Cl, -Br, -I, -CH₂Br, -CH(CH₃)Br, -CH₂-O-C(=O)CH(CH₃)Br, -CH₂-O-C(=O)C(CH₃)₂Br, -OH, -CH₂OH, -SH, -CH₂CH₂SH, -CHO, -COCH₃, COOH et 3,4-(COOH)₂, 3-COOH-4-NO₂, 3,4-(C(=O)F)₂, -CH₂COOH, -CH₂CH₂COOH, -COOC₂H₅, -NHC(=O)Ot-Bu, -NHC(=O)CH₃, -NHC(=O)CF₃, CH₂CH₂NH₃⁺, -CN et 3,4-(CN)₂, 3 et 4-NO₂, pyrrolyle, o-hydroxybenzoïque, 2-(2-thiophén-3-yl-acétyl)-aminoéthyl, 4-benzoylbenzène, 4-(2,5-dioxo-2,5-dihydro-pyrrol-1-yl), 3-isonitrile, le 3-dioxo-1H-isochromène-5-diazonium-3H-benzo[de]chromèn-5-diazonium, 3-(2,5-dioxo-2, 5-dihydro-pyrrol-1-yl) et 4-[1-(2,2,6,6-tétramethyl-pipéridin-1-yloxy)]-éthyle.

La présente invention concerne également un procédé tel que défini ci-dessus, caractérisé en ce que le sel de diazonium est une diazorésine.

L'expression "diazorésine" désigne un polymère obtenu par condensation du formaldéhyde avec des sels de diazonium, et particulièrement avec les sels de diazonium de la diphénylamine substituée ou non. Ces diazorésines sont des composés employés industriellement comme couche photosensible dans la fabrication des plaques pour l'impression (Zhao C., Chen J.Y., Cao, W.X., Angewandte Makromolekulare Chemie, 1998, 259, 77-82 ; Brevet américain n° 6,165,689).

La présente invention concerne un procédé tel que défini ci-dessus, caractérisé en ce que le matériau isolant est de nature organique et est choisi parmi :
- les polymères aromatiques suivants : le polycarbonate (PC), le polysulfure de phénylène (PPS), le polyphénylène éther (PPE), le polyétheréther cétone (PEEK), le polytéréphtalate d'éthyle (PET), le polyéther sulfone (PES), le polyamide aromatique (PPA), le polytéréphtalate de bisphénol (PAR), le polyétherimide (PEI), le polyamide-imide (PAI, Torlon^{®}), le polypyrromellitide (Kapton^{®}), le polystyrène (PS), le poly(4-méthylstyrène), le poly(4-vinylpyridine)(4VP) ou le poly(2-vinylpyridine)(2VP), le polyvinylcarbazole, et
- les polymères aliphatiques suivants : le polyéthylène (PE), le polypropylène (PP), le polyisobutylène (P-IB), le polyméthylpentène, le polychlorure de vinyle (PVC), le polyacétate de vinyle (PVAC), le polybutyral de vinyle (PVB), le polyformal de vinyle (PVFM), le polyacrylate de méthyle (PMMA), le polyalcool vinylique (PVAL), le polyéthylène téréphtalate (PET), le polyisobutylène téréphtalate (PBT), les différents polyamides, les polyoxométhylènes (POM), les dérivés cellulosiques et le polyacrylonitrile (PAN).

La présente invention concerne un procédé tel que défini ci-dessus, caractérisé en ce que le matériau isolant ou le composé binaire ou ternaire est choisi parmi : Si dopé ou non, AsGa, SiO₂, SiC, TiN, TaN, TaN/Ta et WCN.

La présente invention concerne un procédé tel que défini ci-dessus, caractérisé en ce qu'il comprend l'utilisation d'un réducteur.

L'expression "réducteur" désigne un composé susceptible de fournir un électron à un oxydant.

Selon un mode de réalisation avantageux du procédé de l'invention, le réducteur est choisi parmi : les réducteurs ayant des potentiels d'oxydation voisins de 0 V/SCE ou négatifs, l'acide hypophosphoreux, les sels d'halogénures, notamment l'iodure de sodium, le ferrocène et ses dérivés, notamment le férrocène-méthanol ou l'acide ferrocène carboxylique, l'acide ascorbique, le diméthylaminoborane, le borohydrure de sodium, les sels de viologène, notamment le méthyl- ou le benzylviologène, et les phénolates, notamment les bisphénolates.

Selon un mode de réalisation avantageux, lorsque le procédé de l'invention comprend l'utilisation d'un réducteur, ledit procédé est caractérisé en ce qu'il comprend la mise en contact de la surface avec le sel de diazonium et le réducteur, ledit réducteur étant présent en quantité stoechiométrique ou supérieure à la stoechiométrie par rapport audit sel de diazonium.

Selon un mode de réalisation avantageux, lorsque le procédé de l'invention comprend l'utilisation d'un réducteur, ledit procédé est caractérisé en ce qu'il est effectué en solution aqueuse ou dans un solvant aprotique choisi parmi : l'acétonitrile, le diméthylformamide, le benzonitrile, le butyronitrile, le diméthylsulfoxyde, le tétrahydrofurane, le dioxanne et l'acétamide.

La présente invention concerne également un procédé tel que défini ci-dessus, caractérisé en ce qu'il comprend l'irradiation photochimique d'un complexe de transfert de charges formé à partir du sel de diazonium.

Selon un mode de réalisation préféré, le procédé de l'invention comprend la formation d'un complexe de transfert de charges par la réaction d'un sel de diazonium et d'un composé aromatique donneur d'électrons, et l'irradiation dudit complexe de transfert de charges, pour obtenir la réduction du sel de diazonium et la formation de radicaux aryles qui se lient à ladite surface.

Selon un mode de réalisation particulier, le procédé de l'invention comprend l'irradiation photochimique d'un complexe de transfert de charges formé à partir du sel de diazonium et est caractérisé en ce qu'il comprend les étapes suivantes :
- la mise en contact de la surface avec le sel de diazonium et un composé aromatique donneur d'électrons, pour obtenir un complexe de transfert de charges, et
- l'irradiation, notamment par photochimie, dudit complexe de transfert de charges, pour obtenir la réduction du sel de diazonium et la formation de radicaux aryles qui se lient à ladite surface.

Selon un mode de réalisation particulier, le procédé de l'invention tel que défini ci-dessus, comprenant l'irradiation photochimique d'un complexe de transfert de charges formé à partir du sel de diazonium, est caractérisé en ce que le composé aromatique donneur d'électrons provient de la surface à modifier, ladite surface étant un polymère aromatique choisi parmi : le polycarbonate (PC), le polysulfure de phénylène (PPS), le polyphénylène éther (PPE), le polyétheréther cétone (PEEK), le polytéréphtalate d'éthyle (PET), le polyéther sulfone (PES), le polyamide aromatique (PPA), le polytéréphtalate de bisphénol (PAR), le polyétherimide (PEI), le polyamide-imide (PAI, Torlon^{®}), le polypyrromellitide (Kapton^{®}), le polystyrène (PS), le poly(4-méthylstyrène), le poly(4-vinylpyridine)(4VP) ou le poly(2-vinylpyridine)(2VP) et le polyvinylcarbazole.

Selon un mode de réalisation préféré, le procédé de l'invention tel que défini ci-dessus, comprenant l'irradiation photochimique d'un complexe de transfert de charges formé à partir du sel de diazonium, est caractérisé en ce qu'il est effectué dans un solvant aprotique choisi parmi : l'acétonitrile, le diméthylformamide, le benzonitrile, le butyronitrile, le diméthylsulfoxyde, le tétrahydrofurane, le dioxanne et l'acétamide.

Selon un mode de réalisation préféré, le procédé de l'invention tel que défini ci-dessus, comprenant l'irradiation photochimique d'un complexe de transfert de charges formé à partir du sel de diazonium, est caractérisé en ce que le composé aromatique donneur d'électrons est choisi parmi : le 1,4-diméthoxybenzène, le toluène, le *p*-xylène, le mésitylène, le naphtalène, l'anthracène, le pyrène, le *p-*diméthoxybenzène et le *p-*diéthoxybenzène.

Selon un mode de réalisation avantageux, le procédé de l'invention tel que défini ci-dessus, comprenant l'irradiation photochimique d'un complexe de transfert de charges formé à partir du sel de diazonium, est caractérisé en ce que le sel de diazonium est choisi parmi : le 4-bromobenzène diazonium, le 4-iodobenzène diazonium et l'acide 4-diazoniumbenzoïque.

La présente invention concerne également un procédé tel que défini ci-dessus, caractérisé en ce qu'il comprend l'utilisation d'ultrasons.

Selon un mode de réalisation préféré, le procédé de l'invention est caractérisé en ce qu'il comprend une étape de mise en contact de la surface avec le sel de diazonium et de traitement aux ultrasons.

Selon un autre mode de réalisation préféré, le procédé de l'invention est caractérisé en ce qu'il comprend une seule étape au cours de laquelle le matériau est plongé dans la solution de sel de diazonium irradiée par des ultrasons.

Selon un mode de réalisation avantageux, le procédé de l'invention tel que défini ci-dessus, comprenant l'utilisation d'ultrasons, est caractérisé en ce qu'il est effectué en milieu aqueux acide, dans l'alcool éthylique ou dans un solvant aprotique choisi parmi : l'acétonitrile, le diméthylformamide, le benzonitrile, le butyronitrile, le diméthylsulfoxyde, le tétrahydrofurane, le dioxanne et l'acétamide.

La présente invention concerne également des surfaces modifiées d'un matériau isolant de nature organique ou inorganique ou d'un matériau semi-conducteur de nature inorganique ou d'un composé binaire ou ternaire ou d'un matériau composite, obtenues par la mise en oeuvre du procédé tel que défini ci-dessus.

Le procédé de l'invention permet de préparer des surfaces modifiées de polymères ou de composés inorganiques dont la structure et la composition interne sont indépendantes de celles de la surface. On peut alors conférer à la surface des propriétés spécifiques. Par exemple, on peut préparer des polymères dont les propriétés mécaniques sont assurées par la nature chimique des chaînes aliphatiques ou aromatiques et dont la surface possède des fonctions ajustables en fonction de l'objectif d'application visé (biomédical, médicament supporté...). Le procédé de l'invention permet également de préparer des matériaux inorganiques possédant en surface des fonctions organiques et pouvant servir de capteur ou de couche spécifique en microélectronique.

Selon un mode de réalisation particulièrement avantageux, les surfaces modifiées selon le procédé de l'invention sont caractérisées en ce le groupe aromatique greffé est susceptible de subir des réactions ultérieures de fonctionnalisation.

L'expression "réactions ultérieures de fonctionnalisation" désigne par exemple la réaction de couplage, sur la couche initialement greffée, d'une molécule à activité pharmacologique par exemple d'un anti-inflammatoire, d'un antibiotique, d'un antimitotique, d'une enzyme, d'un complexant, d'un polymère, d'un colorant, mais aussi (dans le cas des substrats inorganiques) de molécules complexantes pouvant servir à la fabrication de capteurs.

### DESCRIPTION DES FIGURES

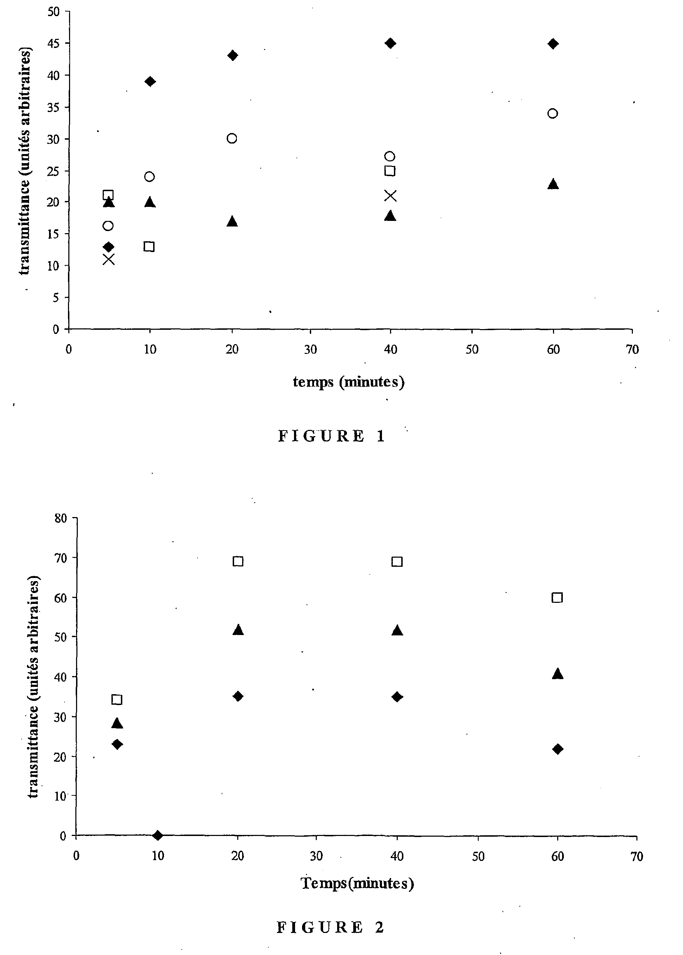

La Figure 1 concerne le greffage de polypropylène (PP) sous Ultrasons par le 4-trifluorobenzènediazonium. Elle représente la variation de l'intensité des bandes CF₃ en fonction du temps. Les séries 1 (losanges noirs), 2 (carrés blancs), 3 (triangles noirs) et 4 (croix noires) correspondent respectivement à la variation des bandes du PP greffé par des groupes C₆H₄CF₃ à 1340, 1160, 1070 et 997 cm⁻¹. La série 5 (ronds blancs) correspond à la moyenne des autres séries.
La Figure 2 concerne le greffage de polyéthylène (PET) sous Ultrasons par le 4-trifluorobenzènediazonium. Elle représente la variation de l'intensité des bandes CF₃ en fonction du temps. Les séries 1 (losanges noirs) et 2 (carrés blancs) correspondent respectivement à la variation des bandes du PET greffé par des groupes C₆H₄CF₃ à 1337 et 1102 cm⁻¹ et la série 3 (triangles noirs) correspond à la moyenne des séries 1 et 2.

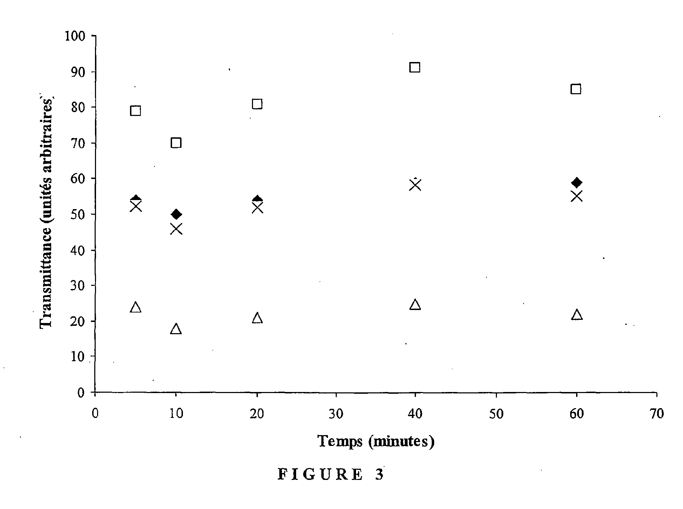

La Figure 3 concerne le greffage de polyétheréther cétone (PEEK) sous Ultrasons par le 4-trifluorobenzènediazonium. Elle représente la variation de l'intensité des bandes CF₃ en fonction du temps. Les séries 1 (losanges noirs), 2 (carrés blancs) et 3 (triangles noirs) correspondent respectivement à la variation des bandes du PEEK greffé par des groupes C₆H₄CF₃ à 1309, 1160 et 1099 cm⁻¹. La série 4 (croix noires) correspond à la moyenne des séries précédentes.

### PARTIE EXPÉRIMENTALE

Dans la présente demande, le greffage de groupes aromatiques sur des polymères est assuré par réduction par des réducteurs homogènes, par photochimie ou par activation par des ultrasons.

Des essais de greffage en l'absence d'activation (blancs de réaction) ont été effectués au préalable, montrant clairement qu'une activation est indispensable pour que les sels de diazonium puissent réagir sur des polymères ou des diélectriques.

**Tableau 1. Essais de greffage sans activation de 4-nitrobenzène diazonium**

| Substrat | Solvant | | |
|---|---|---|---|
| | ACN | H₂SO₄ 0,1 N | EtOH |
| PE ^{a)} | néant ^{b)} | néant^{c)} | néant^{c)} |
| PP néant^{a)} | néant^{b)} | néant^{c)} | néant^{c)} |
| Kapton^{® a)} | néant^{b)} | néant^{c)} | néant^{c)} |
| PET^{a)} | néant^{b)} | néant^{c)} | néant^{c)} |
| PEEK^{a)} | néant^{b)} | néant^{c)} | néant^{c)} |
| Teflon^{® a)} | néant^{b)} | néant^{c)} | néant^{c)} |
| ABS^{a)} | néant ^{b)} | néant^{c)} | néant^{c)} |
| SiO₂^{d)} | ε^{b) d)} | --- | --- |
| TiN^{d)} | ε^{b) d)} | --- | --- |

| | | | |
|---|---|---|---|
| a) recherche par IR des bandes caractéristiques de la fonction chimique -NO₂ après avoir laissé le polymère en contact avec la solution pendant une heure, suivie d'un rinçage à l'eau puis à l'acétone sous ultrasons, "*néant*" signifie que ces bandes IR ne sont pas détectées ; b) c = 0,22M ; c) solution saturée c ≤ 0,22M ; d) à la limite de détection du ToF-SIMS, l'intensité des pics caractéristiques est proche de celle d'un échantillon non traité. | | | |

D'autre part, des réactions ont été effectuées à des concentrations plus faibles que celles utilisées dans la présente demande : les résultats du tableau 2 montrent effectivement qu'il faut utiliser des concentrations élevées pour pouvoir détecter le greffage.

**Tableau 2. Essais de greffage à faible concentration de 4-nitrobenzène diazonium**

| Substrat | Solvant Concentration | Activation | Résultat |
|---|---|---|---|
| PP PET Kapton® | ACN 10 mM | Ultrason^{a)} | Néant^{b)} |
| PET | ACN 10 mM | Photochimie^{c)} | Néant^{b)} |
| PET | ACN 10 mM | Réduction par du ferrocéneméthabol^{d)} | Néant^{b)} |
| PET | H₂SO₄ 0,1N | Réduction par l'iodure^{e)} | Néant^{b)} |
| SiO₂ | ACN 10 mM | Ultrasons | ε^{g)} |
| TiN | ACN 10 mM | Ultrasons | ε^{g)} |

| | | | |
|---|---|---|---|
| a) 1 heure d'irradiation ; b) les bandes caractéristiques de la fonction chimique -NO₂ ne sont pas détectées par IR ; c) Irradiation pendant 15 minutes avec une lampe de 150W en présence de 11mM de toluène servant à former un complexe de transfert de charge ; d) Solution 10 mM, temps de réaction 5 minutes ; e) Solution 10 mM, temps de réaction 15 minutes ; g) à la limite de la détection du ToF-SIMS, l'intensité des pics caractéristiques est proche de celle d'un échantillon non traité. | | | |

La formation de radicaux à partir de sels de diazonium est la base de la réaction de dédiazotation. Celle-ci peut se faire de manière hétérolytique (formation de Ar⁺) ou homolytique (formation de Ar°). C'est cette dernière réaction que l'on cherche à favoriser (Galli, C. Chem. Rev.1988, 88, 765).

La production des radicaux par des réducteurs et par photochimie des complexes de transfert de charge est basée sur la publication de J. K. Kochi (D. Kosynkin, T. M. Bockman, J. K. Kochi, J. Am. Chem. Soc., 119, 4846, (1997)) qui a montré que les radicaux obtenus par réduction homogène des sels de diazonium se couplaient avec le composé aromatique utilisé comme solvant selon une réaction S_{H} de substitution homolytique aromatique :

ArN₂⁺ + Ar'H → Ar-Ar' + H⁺ + N₂

En l'absence de composés aromatiques utilisés comme solvant, les mêmes radicaux réagissent, en partie avec le solvant et en partie avec le polymère (surface), soit en s'additionnant sur les groupes aromatiques ou les doubles liaisons, soit en arrachant un atome d'hydrogène au polymère pour former un radical susceptible de se coupler avec un radical aryle.

La première réaction est schématisée ci-dessous :

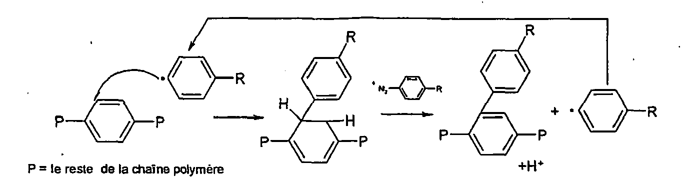

C'est une substitution homolytique aromatique S_{H}, suivie de la réoxydation par le sel de diazonium du radical cyclohexadiényle intermédiaire. C'est la même réaction qui assure la croissance des couches de polyphénylène lors du greffage des sels de diazonium sur le carbone ou le métal (Combellas, C.; Kanoufi, F.; Pinson, J.; Podvorica, F. Langmuir 2005, 21, 280).

L'addition d'un radical aromatique sur une double liaison est une réaction bien connue, c'est la réaction de Merweein (Dombrovski, Rondestvedt, cités ci-dessus)

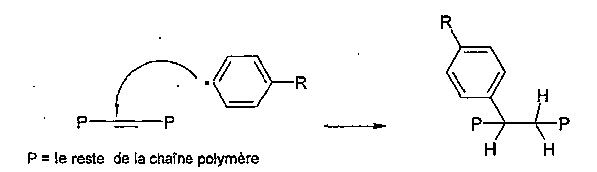

L'arrachement d'un atome d'hydrogène au polymère suivi du couplage de deux radicaux peut s'écrire comme suit :

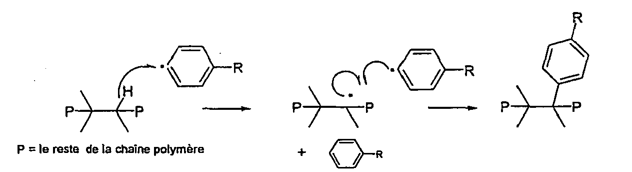

Le mécanisme de formation des radicaux par ultrasons est décrit dans différentes revues (Cravotto, G.; Cintas, P. Chem. Soc. Rev. 2006, 35, 180 et références citées). La formation de radicaux à partir de sels de diazonium a été utilisée pour déclencher des polymérisations (Cheung, M. H.; Gaddam, K. J. Appl. Polym. Sci. 2000, 76, 101 ; Vivekanandam, T.S.; Gopalan, A.; Vasudevan, T.; Umapathy, S. Polymer 1999, 40, 807.)

Surfaces utilisées :
- PP : feuille de polypropylène (fournisseur Goodfellow)
- PET : feuille de polyethyltéréphtalate (fournisseur DSM)
- PEEK : feuille de polyétheréthercétone (fournisseur Goodfellow)
- PE : polyethylène à très haut poids moléculaire (fournisseur Goodfellow)
- Teflon : polytétrafluoroéthylène (fournisseur Goodfellow)
- ABS : acrylonitrile-butadiène-styrène* (fournisseur Goodfellow)
   * obtenu en dispersant une phase élastomérique greffée (butadiène) dans une phase du copolymère styrène-acrylonitrile (SAN)
- Kapton® polyimide (fournisseur Dupont)
- Polyamide (ballons de stents)
- TiN, SiC, SiOC, SiO₂
Sel de diazonium : Tétrafluoroborate de 4-bromobenzène diazonium (Aldrich)

### I - Réduction par des réducteurs homogènes

On a utilisé les deux réducteurs décrits par J. K. Kochi (Kosynkin D., Bockman T. M., Kochi J. K., J. Am. Chem. Soc., 1997, 119, 4846) : NaI et le Ferrocèneméthanol (FcCH₂OH). De façon plus générale, d'autres réducteurs sont possibles par exemple l'hypophosphite (Pandurangappa, M., N., S. Lawrence, R., G. Compton, Analyst, 2002, 1568-1571) ou l'acide ascorbique (Costas-Costas, U.; Bravo-Diaz, C.; Gonzalez-Romero, E. Langmuir 2004, 20, 1631) et plus généralement tous les composés dont le potentiel redox est plus positif que celui du sel de diazonium (c'est-à-dire plus négatif que 0,5V/SCE de façon à réduire tous les sels de diazonium).

### Exemple 1 - Utilisation de NaI comme réducteur :

Dans un tube à essai, on introduit un échantillon d'une surface à modifier. On prépare par ailleurs deux solutions
1- 14 mL d'acétonitrile (ACN) + 1,12 g de 4-bromobenzènediazonium (1,47 M)
2- 14 mL d'acétonitrile (ACN) + 0,609 g de NaI (1,47 M)

Cette expérience est effectuée à des concentrations très proches de la limite de solubilité du 4-bromobenzènediazonium.

On ajoute dans chaque tube à essai 2 mL de la solution 1 puis 2 mL de la solution 2. On homogénéise le mélange de ces deux solutions en plongeant une seconde le tube à essai dans une cuve à ultrasons. On observe un violent dégagement d'azote, le mélange mousse. Le mélange devient brun (I₂). On laisse reposer 1 heure. Les échantillons sont rincés à l'eau sous ultrasons (10 minutes), deux fois à l'acétone (pour analyse)(10 minutes) et séchés sous vide pendant 18 heures.

**Tableau 3. Analyse ToF-SIMS de polymères greffés par des groupes 4-bromophényle.**

| Surfaces | Pics (Intensité*) | Attribution |
|---|---|---|
| PP | 79-81 (0.3 10⁴) | Br⁻ |
| | 127((2 10³) | I⁻ |
| PET | 79-81 (1 10⁴) | Br⁻ |
| | 139-141 (0.5 10⁴) | [OCH₂CH₂O + Br]⁻ |
| | 167-169 (2 10³) | [O=COCH₂CH₂O + Br]⁻ |
| | 213 | [O=COCH₂CH₂O + I]⁻ |
| PEEK | 79-81 (1.5 10⁴) | Br⁻ |
| | 127 (0.4 10⁴) | I⁻ |
| TiN | 79-81 (2 10⁴) | Bi |
| | 127 (6 10⁴) | I⁻ |
| SiC | 79-81 (2 10⁴) | Br⁻ |
| | 127 (3.5 10⁴) | I⁻ |
| SiOC | 79-81 (0.3 10³) | Br⁻ |
| | 127 (1 10²) | I⁻ |
| SiO₂ | 79-81 (0.8 10³) | Br⁻ |
| | 127 (1 10³) | I⁻ |

| | | |
|---|---|---|
| * Unités arbitraires | | |

La présence de brome sur la surface des polymères et plus encore de fragments bromés du polymère PET montre clairement que le diazonium réagit avec la surface des polymères et des diélectriques. On peut par ailleurs noter la présence d'iode sur la surface, ce qui indique que des atomes d'iode provenant du réducteur NaI ont réagi sur la surface.

### Exemple 2 - Utilisation du Ferrocèneméthanol (FcCH₂OH) comme réducteur :

Dans un tube à essai, on introduit un échantillon d'une surface à modifier. On prépare par ailleurs une solution
1- 14 mL d'acétonitrile (ACN) + 0,39 g de 4-bromobenzènediazonium (0,1 M)
2- 14 mL d'acétonitrile (ACN) + 0,30 g de FcCH₂OH (0,1 M)

On ajoute dans chaque tube à essai 2 mL de la solution 1 puis 2 mL de la solution 2 (concentration finale 0,05 M). On homogénéise le mélange formé par ces deux solutions en plongeant cinq minutes le tube à essai dans une cuve à ultrasons. On observe un dégagement d'azote. Le mélange passe de orangé à vert foncé. On laisse reposer 1 heure. Les échantillons sont rincés deux fois à l'acétone (pour analyse) (10 minutes) et séchés sous vide pendant 18 heures.

**Tableau 4. Analyse ToF-SIMS de polymères greffés par des groupes 4-bromophényle.**

| Echantillon | Pics (Intensité*) | Attribution |
|---|---|---|
| PP | 79-81 (0.6 10⁴) | Br⁻ |
| PET | 79-81 (1 10⁴) | Br⁻ |
| | 93-95 (3 10³) | CH₂Br |
| | 125-127 (3 10³) | [BrCOOH₂]⁻ |
| | 139-141 (56 10³) | [BrCH₂COOH₂]⁻ |
| | 153-155 (1 10³) | [BrCH₂CH₂COOH₂]⁻ |
| PEEK | 79-81 (1.5 10⁴) | Br⁻ |
| TiN | 79-81 (3 10⁵) | Br⁻ |
| SiC | 79-81 (0.6 10⁴) | Br⁻ |
| SiOC | 79-81 (2 10³) | Br⁻ |
| SiO₂ | 79-81 (0.5 10⁴) | Br⁻ |

| | | |
|---|---|---|
| * Unités arbitraires | | |

La présence de brome sur la surface des polymères et plus encore de fragments bromés du polymère PET montre clairement que le diazonium réagit avec la surface des polymères et des diélectriques.

### Exemple 3

Des groupes -C₆H₄COOH ont été greffés par réduction du tétrafluoroborate de diazonium correspondant par le ferrocène méthanol selon le mode opératoire suivant.

On prépare :
a) une solution de 175 mg deBF₄^{- +}N₂C₆H₄COOH dans 7,5 mL d'ACN (c= 0,1 M) ; et
b) une solution de 162 mg de ferrocèneméthanol (FcCH₂OH) dans 7,5 mL d'ACN (c=0,1 M).

On ajoute 2,5 mL de la solution a) dans un tube à hémolyse contenant un échantillon de polymère (voir tableau 3) puis 2,5 mL de la solution b) (concentrations finales 50 mM de ⁺₂NC₆H₄COOH et 50 mM de FcCH₂OH) : le mélange de ces deux solutions devient vert foncé et des bulles d'azote se dégagent. On place alors le mélange sous ultrasons pendant 10 minutes. Les échantillons sont rincés sous ultrasons dans l'acétone (10 minutes), l'eau (10 minutes) et l'ACN pour analyse (10 minutes).

**Tableau 5. Analyse IR de polymères greffés par des groupes 4-carboxyphényles.**

| Echantillon | Bande IR¹⁾ cm⁻¹ | Attribution | Acide 4-aminobenzoique²⁾ cm⁻¹ |
|---|---|---|---|
| PP | 1687 | C=O | 1658 |
| | 1617 | Vibration du cycle | 1599 |
| PET | 1681³⁾ | C=O | 1658 |
| PEEK | /⁴⁾ | / | |

| | | | |
|---|---|---|---|
| 1) après soustraction du spectre du polymère 2) solide 3) épaulement sur la bande ester du PET 4) les bandes C=O du PEEK et du groupe C₆H₄COOH sont trop proches pour être distinguées. | | | |

Les angles de contact de l'eau ont également été mesurés avant et après traitement par le réducteur :

**Tableau 6. Angles de contact d'échantillons greffés par le sel de diazonium de l'acide 4-aminobenzoïque.**

| Echantillon | Angle de contact avant traitement | Angle de contact après traitement |
|---|---|---|
| PP^{a)} | 124 | 114 |
| | | 72 (après 10 minutes) |
| | | 69 (après 20 minutes) |
| PET | 90 | 62 |
| PEEK | 87 | 55 (après 10') |

| | | |
|---|---|---|
| a) l'angle met quelque temps à atteindre une valeur limite sans qu'il y ait une évaporation notable de la goutte. | | |

La présence des bandes IR correspondant au groupe C=O et au cycle aromatique ainsi que le caractère plus hydrophile de la surface témoignent du greffage du groupe phénylcarboxylique sur la surface.

### Exemple 4 - Utilisation de l'acide hypophosphoreux comme réducteur :

L'acide hypophosphoreux a été utilisé pour réduire les sels de diazonium (Pandurangappa et al., 2002, cité plus haut ; Miklukhin, G. P.; Rekasheva, A. F.; Pisarzhevskii, L. V. Doklady Akad. Nauk., 1952, 85, 82 ; Kornblum, N.; Kelley, A. E.; Cooper, G. D. J. Am. Chem. Soc., 1952, 74, 3074) et en particulier en présence de noir de carbone, ce qui permet de modifier la surface du noir de carbone par les groupes aryles provenant du diazonium.

Dans trois tubes à hémolyse contenant chacun un échantillon de polymère (feuille de PP, PET, PEEK), on place 190 mg de tétrafluoroborate de 4-iodobenzènediazonium (concentration finale 0,15 M) puis on ajoute 4 mL d'acide hypophosphoreùx 50% en solution aqueuse (concentration finale 0,15 M). Les tubes sont placés 10 minutes dans une cuve à ultrasons pour homogénéiser le mélange, le sel de diazonium se dissout progressivement. A la fin de la réaction, il se forme un précipité et on observe un surnageant huileux ainsi qu'une forte odeur aromatique, indiquant probablement la formation d'iodobenzène (Miklukhin et al., 1952 - cité ci-dessus). Les échantillons sont rincés sous l'eau du robinet, puis deux fois à l'eau distillée (10 minutes sous ultrasons) et enfin à l'acétonitrile pour analyse (10 minutes sous ultrasons). Ils sont séchés sous vide à 40°C.

**Tableau 7. Spectre IR d'échantillons traités par le tétrafluoroborate de 4-iodobenzènediazonium.**

| Echantillon | Bande IR¹⁾ cm⁻¹ | Attribution | 4-iodobenzènediazonium |
|---|---|---|---|
| PP | 1541 | Vibration du cycle | 1548 |
| | 812 | CH hors du plan | 825 |
| | | | 757 |
| PET | 1532 | Vibration du cycle | |
| | 845 | CH hors du plan | |
| PEEK | 1562 | Vibration du cycle | |
| | 825 | CH hors du plan | |

| | | | |
|---|---|---|---|
| 1) après soustraction du spectre du polymère. | | | |

**Tableau 8. Spectre ToF-SIMS d'échantillons traités par le tétrafluoroborate de 4-iodobenzènediazonium.**

| Echantillon | Pics (Intensité*) | Attribution |
|---|---|---|
| PP | 127 (2.5 10³) | I⁻ |
| | 205 (6 10¹) | [C₆H₅I + H]⁻ |
| | 231 (1 10¹) | [CH₂CH₂C₆H₄I]⁻ |
| PET | 127 (4 10³) | I⁻ |
| | 214 (210²) | C-C₆H₃-I⁻ |
| | 228(0.510²) | 214 + CH₂⁻ |
| | 242 (0.510²) | 228 + CH₂⁻ |
| | 256 (0.510²) | 242+ CH₂⁻ |
| | 351 (210¹) | C₆H₅(C=O)OCH₂CHC₆H₄I⁻ |
| | | |
| PEEK | 127 (3.5 10³) | I⁻ |
| | 254 (3.5 10¹) | I₂⁻ |

La présence de bandes IR correspondant au groupe aromatique ainsi que des fragments organiques iodés met bien en évidence le greffage du groupe iodophényle.

### Exemple 5

Le même réducteur est utilisé pour réduire le 4-bromobenzène diazonium en présence de PE, Téflon et ABS. Dans trois tubes à essai contenant chacun un échantillon de polymère, on place 272 mg de 4-bromobenzènediazonium tétrafluoroborate et on ajoute 5 mL d'acide hypophosphoreux (solution à 50% dans l'eau). La concentration finale du diazonium est de 0,2 M. Les tubes sont placés 10 minutes dans une cuve à ultrasons pour assurer le mélange. La solution finale est trouble, à forte odeur aromatique. Les échantillons sont abondamment rincés à l'eau chaude sous le robinet puis deux fois 10 minutes sous ultrasons à l'eau distillée, puis 10 minutes dans l'acétone (PP, Téflon) ou l'isopropanol (ABS) sous ultrasons. Ils sont enfin séchés sous vide à 40°C.

**Tableau 9. Spectre IR d'échantillons de polymères (PE, Téflon, ABS), modifiés par des groupes bromophényle.**

| Echantillon | Bande IR¹⁾ cm⁻¹ | Attribution | 4-bromobenzènediazonium |
|---|---|---|---|
| PE | 1555 | Vibration du cycle | 1555 |
| | 843 | CH hors du plan | 826 |
| | 763 | id | 764 |
| Téflon | 1548 | Vibration du cycle | |
| | 852 | CH hors du plan | |
| | 758 | id | |
| ABS | 1584 | Vibration du cycle | |
| | 824 | CH hors du plan | |
| | 744 | id | |

| | | | |
|---|---|---|---|
| 1) après soustraction du spectre du polymère. | | | |

**Tableau 10. Spectre ToF-SIMS d'échantillons de polymères (PE, Téflon, ABS), modifiés par des groupes bromophényle*.**

| Echantillon | Pics (Intensité*) | Attribution |
|---|---|---|
| PE | 79-81 | Br⁻, Br⁺ |
| | 104-106 | CH₃-CH₂Br⁻ |
| | 179-181 | C₂C₆H₄Br⁻ |
| | 197-199 | (CH₂)₃C₆H₄Br⁻ |
| | 225-227 | (CH₂)₅C₆H₄Br⁻ |
| | 264-266 | non attribué |
| | 290-292 | non attribué |
| | 183-185 | (CH₂)₂C₆H₄Br⁺ |
| | 265-267 | (CH₂)₆-CH=CH-C₆H₄Br⁺ |
| Teflon | 79-81 | Br⁻ (faible) |
| ABS | 79-81 | Br⁻, Br⁺ |
| | 191-193 | C₃-C₆H₄Br⁺ |

| | | |
|---|---|---|
| * Seuls sont indiqués les fragments contenant du brome, repéré par deux pics de hauteur sensiblement égale et séparés par deux unités de masse | | |

Les spectres infrarouge et ToF-SIMS indiquent bien l'existence du greffage, en particulier les fragments comportant des groupes bromophényles.

### Exemple 6

Cette même méthode a été utilisée pour modifier la surface de composés binaires ou ternaires ((TiN : 20 nm d'épaisseur), TaN, TaN/Ta (du tantale déposé en couche de 10 nm sur 15 nm de TaN)) et de diélectriques (SiC, SiOC, SiO₂) utilisés en microélectronique. Dans cinq tubes à essais contenant respectivement un échantillon de TiN, TaN/Ta, SiC, SiOC, SiO₂, on ajoute 270 mg de tétrafluoroborate de trifluorométhyl
benzènediazonium (ce qui correspond à une concentration finale de 0,2M). On ajoute dans chaque tube 5 mL de H₂PO₃ (solution aqueuse à 50%), on agite 5 minutes dans une cuve à ultrasons, à la fin une huile surnage sur la solution aqueuse. Les échantillons sont lavés sous l'eau chaude du robinet, 2 fois à l'eau distillée sous ultrasons pendant 10 minutes et une fois à l'acétone sous ultrasons et finalement séchés sous vide à 40°C.

**Tableau 11. Spectres ToF-SIMs de diélectriques et de composés binaires ou ternaires modifiés par des groupes trifluorométhylphényles.**

| Echantillon | m/z | Interprétation |
|---|---|---|
| TaN/Ta | 19 | F⁻ |
| | 69 | CF₃⁻ |
| | 145 | C₆H₄CF₃⁺ |
| | 160 | N-C₆H₄CF₃⁻ |
| TiN et SiC | 19 | F⁻ |
| | 69 | CF₃⁻ |
| | 145 | C₆H₄CF₃^{+ et -} |
| SiOC | 19 | F⁻ |
| | 69 | CF₃⁻ |
| | 145 | C₆H₄CF₃⁺ |
| | 197 | C-C Si-C₆H₄CF₃⁻ |
| | 304 | O-C₆H₃CF₃-C₆H₄CF₃⁻ |
| | 317 | Si-C₆H₃CF₃-C₆H₄CF₃⁻ |
| | 473 | C-Si-C₆H₃CF₃-C₆H₃CF₃-C₅H₄CF₃⁻ |
| SiO₂ | 19 | F⁻ |
| | 69 | CF₃⁻ |
| | 145 | C₆H₄CF₃^{+et-} |
| | 283 | (HOSiO)-SiO₂-O-C₆H₄CF₃⁻ |

Les spectres ToF-SIMS confirment le greffage de groupes trifluorométhylphényles (il faut, en particulier, noter la présence de fragments trifluorométhylphényles) sur la surface des diélectriques, mais il faut noter la présence de résidus de l'acide phosphorique bien visibles sur les spectres.

### II-Réduction par irradiation photochimique de complexes de transfert de charge

Dans l'article de Kosynkin et al. (1997)(déjà cité), J. K. Kochi montre que les sels de diazonium (le pentafluorobenzènediazonium et le 2,4,6-trichloro-3,5-difluorobenzène-diazonium, c'est-à-dire des sels de diazonium portant des groupes chimiques électroattracteurs les rendant plus facilement réductibles) forment avec des aromatiques riches en électrons tels que le naphtalène ou le 1,4-diméthoxybenzène des complexes de transfert de charge caractérisés par des absorptions dans le visible. L'irradiation de ces complexes produit un état excité dans lequel a lieu un transfert d'électron de l'aromatique vers le sel de diazonium, ce qui conduit à la formation de radicaux aryles qui dans le cas de la publication citée réagissent avec le solvant aromatique pour conduire à des biphényles. Cette réaction a été transposée pour obtenir la réaction des radicaux aryles avec les surfaces de nos substrats.

### Exemple 7 - Formation et irradiation d'un complexe de transfert de charge entre le 4-bromobenzènediazonium et le 1,4-dimethoxybenzène:

On prépare deux solutions:
1- dans 14 mL d'ACN, 1,12 g de 4-bromobenzènediazonium (0,30 M)
2- dans 14 mL d'ACN, 0,57 g de 1,4-diméthoxybenzène (0,30M)

On place les échantillons dans un tube à essai et on ajoute 2 mL de chacune des solutions, on observe la couleur jaune d'or du mélange correspondant à la formation du complexe de transfert de charge.

On dépose ensuite là solution sur les échantillons, on laisse évaporer et on introduit dans un tunnel d'irradiation Fisons (lampe H). On effectue 5 passages (vitesse de déroulement du tapis 2 cm/s, soit environ 40 s d'irradiation). On répète deux fois le dépôt et l'irradiation et on termine par 10 passages dans le tunnel. Les échantillons sont soigneusement rincés à l'acétone puis par deux fois à l'acétonitrile pour analyse (toujours sous ultrasons) puis séchés sous vide à 40°C pendant 16 heures.

**Tableau 12. Analyse ToF-SIMS de polymères, de composés binaires ou ternaires et de diélectriques modifiés par photochimie de complexes de transfert de charge**

| Echantillon | Pics (Intensité*) | Attribution |
|---|---|---|
| PP | 79-81 (1,5 10⁵) | Br⁻ |
| | 91-93(1 10³) | CBr⁻ |
| | 103-105 (0,5 10³) | CH₂CH₂Br |
| PET | 79-81(1 10⁴) | Br⁻ |
| | 93-95 (0,8 10⁴) | [CH₂Br]⁻ |
| PEEK | 79-81 (1 10⁵) | Br⁻ |
| TiN | 79-81 (0,5 10⁴) | Br⁻ |
| SiC . | 79-81 (7 10⁴) | Br⁻ |
| SiOC | 79-81 (1,5 10³) | Br⁻ |
| SiO₂ | 79-81 (0,2 10³) | Br⁻ |

| | | |
|---|---|---|
| * Unités arbitraires | | |

La présence du brome sur le spectre ToF-SIMS est bien compatible avec le greffage des groupes 4-bromophényles sur la surface.

### Exemple 8 - Formation et irradiation d'un complexe de transfert de charge entre le sel de diazonium de l'acide 4-aminobenzoïque et le 1,4-diméthoxybenzène

Trois échantillons de polymères sont scotchés sur une plaque de verre et on dépose sur ces échantillons à l'aide d'une pipette une solution contenant 0,4 M de sel de diazonium de l'acide 4-aminobenzoïque et 0,4 M de 1,4-diméthoxybenzène dans l'acétonitrile (ACN)(la concentration finale est donc de 0,2 M). La solution mouille bien le PEEK, moyennement le PET et très mal le PP (il faut étaler sans arrêt la solution en laissant l'ACN s'évaporer). Après 5 passages dans le tunnel d'irradiation (Fisons, lampe H à mercure) soit environ 20 secondes d'irradiation, les solutions sont entièrement évaporées sous la chaleur de la lampe. Les rinçages sont effectués à l'acétone et deux fois à l'ACN (pour analyse) sous ultrasons pendant 10 minutes et le séchage se fait sous vide à 40°C.

**Tableau 13. Analyse IR de polymères greffés par des groupes 4-carboxyphényles.**

| Echantillon | Bande IR¹⁾ cm⁻¹ | Attribution | Acide 4-aminobenzoique ²⁾ cm⁻¹ |
|---|---|---|---|
| PP | 1686 | C=O | 1658 |
| PET | ≈1681³⁾ | C=O | 1658 |
| PEEK | /⁴⁾ | / | |

| | | | |
|---|---|---|---|
| 1) après soustraction du spectre du polymère. 2) solide. 3) épaulement. 4) les bandes C=O du PEEK et du groupe C₆H₄COOH sont trop proches pour être distinguées. | | | |

Les angles de contact de l'eau ont été mesurés avant et après traitement par le complexe de transfert de charges.

**Tableau 14. Angles de contact d'échantillons greffés par le sel de diazonium de l'acide 4-aminobenzoïque.**

| Echantillon | Angle de contact avant-traitement | Angle de contact après traitement |
|---|---|---|
| | | 123 |
| PP^{a)} | 124 | 72 (après 10 minutes) |
| | | 70 (après 20 minutes) |
| PET | 90 | 79 |
| PEEK | 87 | 58 |

| | | |
|---|---|---|
| a) l'angle met quelque temps à atteindre une valeur limite sans qu'il y ait une évaporation notable de la goutte. | | |

La présence des bandes C=O du groupe carboxyphényle et le caractère plus hydrophile de la surface mettent bien en évidence le greffage du groupe chimique carboxyphényle.

### Exemple 9 - Greffage de groupes bromophényles et trifluorophényles en irradiant la surface en présence de sels de diazonium

Dans l'exemple précédent, un aromatique riche en électron a été ajouté à la solution irradiée pour former le complexe de transfert de charge. Dans cet exemple, le composé aromatique a été supprimé afin que le polymère lui-même (PEEK, PET, ABS, riches en électron) puisse servir à former le complexe de transfert de charge.

Sur deux échantillons de chacun des polymères PEEK, PET, ABS, on dépose sur l'un une solution saturée de 4-bromobenzènediazonium dans H₂SO₄ O,1N et sur l'autre une solution saturée de 4-trifluorométhylbenzènediazonium dans H₂SO₄ 0,1N. Ces échantillons sont irradiés dans un tunnel sous une lampe à vapeur de mercure(lampe H) pendant environ 100 secondes. Les échantillons sont abondamment lavés à l'eau chaude puis deux fois à l'eau distillée sous ultrasons pendant 10 minutes puis à l'acétone sous ultrasons pendant 10 minutes et séchés sous vide.

**Tableau 15. Analyse Tof-SIMS d'échantillons modifiés par des groupes bromo- ou trifluorométhylphényles.**

| Echantillon | m/z | Attribution |
|---|---|---|
| PEEK + 4-bromobenzènediazonium | 79, 81 | Br⁻ |
| | 158, 160, 162 | Br₂⁻ |
| | 171, 173 | O-Br⁻ |
| PEEK + 4-trifluorométhylbenzènediazonium | 19 | F⁻ |
| | 145 | C₆H₄CF₃⁻ |
| PET + 4-bromobenzènediazonium | 79, 81 | Br⁻ |
| PET + 4-trifluorométhylebenzènediazonium | 19 | F⁻ |
| | 69 | CF3⁻ |
| | 145 | C₆H₄CF₃⁻ ; C₆H₄CF₃⁺ |
| ABS + 4-bromobenzènediazonium | 79, 81 | Br⁻ |
| ABS + 4- trifluorométhylbenzènediazonium | 19 | F⁻ |
| | 69 | CF3⁻ |
| | 145 | C₆H₄CF₃⁻ |
| | 345 | CH₃-CH(C₆H₄CF₃)-CH₂CH(C₆H₄CF₃) |

La présence du brome et des groupes trifluorométhylphényles sont caractéristiques du greffage des groupes bromophényles et trifluorométhylphényles sur la surface des polymères.

### III - Utilisation d'ultrasons

| | |
|---|---|
| Surfaces utilisées : | PP : feuille de polypropylène (fournisseur Goodfellow) |
| | PET : feuille de polyéthyltéréphtalate (fournisseur DSM) |
| | PEEK : feuille de polyétheréthercétone (fournisseur Goodfellow) |
| | TiN, SiC, SiOC, SiO₂ |
| Sel de diazonium : | Tétrafluoroborate de 4-bromobenzène diazonium (Aldrich) |
| | Tétrafluoroborate de 4-nitrobenzène diazonium (Aldrich) |
| | Tétrafluoroborate de diazonium de l'acide 4-aminobenzoïque (Alchimer) |
| | Tétrafluoroborate de 4-trifluoromethylbenzène diazonium (Alchimer) |

La cuve à ultrasons utilisée est une cuve Sonorex Super RK 103H de puissance 2 x 320 W utilisée à la moitié de sa puissance, sa fréquence est de 35 kHz.

L'utilisation d'ultrasons de puissance (Power Ultrasound (20 à 100kHz) peut activer ou déclencher des réactions chimiques et cette méthode a fait l'objet d'une revue récente (Cravotto, G.; Cintas, P. Chem. Soc. Rev 2006, 35, 180). Les effets chimiques des ultrasons sont liés au phénomène de cavitation qui produit localement de hautes températures et pressions. Un des résultats de ce phénomène est la formation de radicaux. Ainsi, les radicaux obtenus à partir de l'azo-bisisobutyronitrile et du peroxydisulfate ont été utilisés pour déclencher la polymérisation de l'acrylamide (Cheung, M. H.; Gaddam, K. J. Appl. Polym. Sci. 2000, 76, 101). La décomposition de sels de diazonium en radicaux sous ultrasons a été observée par des expériences de spintrapping (Rehorek, D.; Janzen, E. G. J. Prakt. Chem. 1984, 326, 935)*.* On a donc utilisé les radicaux provenant de la décomposition des sels de diazonium et de peroxydes pour modifier la surface de polymères et de diélectriques.

### Exemule 10: Greffage de polypropylène par des groupes nitrophényles

Dans un tube à essai contenant un échantillon de polypropylène (PP), on introduit 25 mL d'ACN et 1g de tétrafluoroborate de 4-nitrobenzènediazonium (c= 0,16 M) et on laisse sous ultrasons 1h10. L'échantillon est soigneusement rincé sous ultrasons pendant 10 minutes à l'acétone puis dans le méthanol (pour analyse). L'analyse par XPS de l'échantillon montre la présence d'un pic N1s à 402 eV, qui correspond probablement à l'azote du groupe nitro (-NO₂) qui a été réduit en amine sous le faisceau de rayons X, comme cela est fréquemment observé (P. Mendes, M. Belloni; Ashworth; C. Hardy; K. Nikitin; D. Fitzmaurice; K. Critchley; S. Evans; J. Preece Chem. Phys. Chem. 2003, 4, 884).

### Exemple 11: Greffage de polymères et de substrats de la microélectronique par des groupes bromophényles - Solution dans l'acétonitrile

Dans les mêmes conditions que ci-dessus en utilisant le tétrafluoroborate de 4-bromobenzènediazonium on traite à la fois des surfaces polymériques, des surfaces de composés binaires ou ternaires et des surfaces isolantes (SiC, SiO₂, SiOC) de la microélectronique.

**Tableau 16. Analyse ToF-SIMS d'échantillons greffés par le 4-bromobenzènediazonium**

| Surfaces | Pics (intensité*) | Attribution |
|---|---|---|
| PP | 79-81 (3 10³) | Br⁻ |
| PET | 79-81 (1 10⁴) | Br⁻ |
| | 93-95 (0.5 10⁴) | CH₂Br |
| PEEK | 79-81 (3 10⁴) | Br⁻ |
| TiN | 79-81 (6 10⁵) | Br⁻ |
| SiC | 79-81 (0.8 10⁵) | Br⁻ |
| SiOC | 79-81 (2 10³) | Br⁻ |
| SiO₂ | 79-81 (4 10⁵) | Br⁻ |

| | | |
|---|---|---|
| *unités arbitraires | | |

La présence du brome témoigne du greffage du groupe bromophényle sur la surface.

### Exemple 12: Greffage de la surface de polymères par des groupes bromophényles. Réaction en solution aqueuse.

Une solution 0,2 M de 4-bromomobenzènediazonium tétrafluoroborate dans H₂SO₄ 0,1M (solution pratiquement saturée) est répartie entre trois tubes à essais contenant des échantillons de polymères (PP, PET, PEEK, PE, Téflon, ABS). Les tubes sont placés pendant une heure dans une cuve à ultrasons. Les échantillons sont ensuite rincés à l'eau chaude sous le robinet, deux fois à l'eau distillée sous ultrasons (10 minutes) et à l'acétone ou à l'isopropanol (ABS) et finalement séchés sous vide.

**Tableau 17. Analyse IR de polymères modifiés en surface par des groupes bromophényles.**

| Echantillon | Bande IR¹⁾ cm⁻¹ | Attribution | 4-bromobenzènediazonium |
|---|---|---|---|
| PET | 1551 (épaulement) | Vibration du cycle | 1555 |
| | | | 1460 |
| | 837 | Vibration CH | 826 |
| | 758 | hors du plan | 756 |
| PEEK | 1553 | Vibration du cycle | |
| | 1465 | | |
| | 830 | Vibration CH | |
| | 759 | hors du plan | |
| PE | 1551 | Vibration du cycle | |
| | 852 | Vibration CH | |
| | 739 | hors du plan | |
| Téflon | 1551 | Vibration du cycle | |
| | 810 | Vibration CH | |
| | 756 | hors du plan | |
| ABS | 1550sh | Vibration du cycle | |
| | 824 | Vibration CH hors du plan | |

| | | | |
|---|---|---|---|
| 1) après soustraction du spectre du polymère. | | | |

**Tableau 18. Analyse ToF-SIMS d'échantillons greffés par le 4-bromobezènediazonium, sous ultrasons en solution aqueuse***

| Substrat | Pics | Attribution |
|---|---|---|
| PE | 79-81 | Br⁻ |
| | 91 | C₆H₅CH₂⁻ |
| | 295 | CH₃-(CH₂)₂₀⁻ |
| | 371 | CH₃-(CH₂)₂₀-C₆H₄ |
| | 79-81 | Br⁺ |
| | 339-341 | CH₃-(CH₂)₁₂-C₆H₄Br+1 |
| PP | 79-81 | Br⁻ |
| | 91 | C₆H₅CH2⁻ |
| | 231-233 | C₆H₄-C₆H₄Br⁻ |
| | 255-257 | C₂-C₆H₄-C₆H₄Br⁻ |
| | 277-279 | (CH₂)₃C₆H₆-C₆H₆Br⁻ |
| | 336 | (CH₂)₂₄⁻ |
| | 487-489 | (CH₂)₂-(C₆H₄)₄-C₆H₄Br⁻ |
| | 79-81 | Br⁺ |
| | 91 | C₆H₅CH2⁺ (ion tropylium) |
| | 175-177 | CH₂C₆H₁₀-Br |
| | 254-256 | C₂-C₆H₄-C₆H₄Br⁺- 1 |
| PET | 79-81 | Br⁻ |
| | 93-95 | CH₂Br⁻ |
| | 247-249 | CH₂-C₆H₄-C₆H₄Br⁻ +2 |
| | 261-263 | CH₂-CH₂-C₆H₄-C₆H₄Br⁻ +2 |
| | 606-607-608 | [C₆H₄COO(CH₂)₂OOCC₆H₄CO + 2 C₆H₄Br]⁻ |
| | 79-81 | Br⁺ |
| | 167-169 | C-C₆H₄Br⁺ |
| | 267-269 | C₃-C₆H₄-C₆H₄Br⁺ |
| PEEK | 79-81 (3 10⁴) | Br⁻ |
| | 121-123 | CH₂COBr⁺ |
| | 261-263 | C₆H₅-(CO)-C₆H₄Br⁺ |
| | 606-607-608-609 | 3 C₆H₅Br⁺? |
| Teflon® | 79-81 traces | Br⁻ |
| ABS | 79-81 | Br⁻ |
| | 195-197 | CH₂(CN)C₆H₄Br⁻ |
| | 221-223; 223-225 | 221-223 = 195-197 + 26 (CN) |
| | 155-157 | C₆H₄Br⁺ |

| | | |
|---|---|---|
| * Ne sont indiqués sauf exception que les pics correspondant à des produits bromés caractérisés par la présence des deux isotopes du brome 79 et 81 (présentant deux pics de hauteur très voisines et séparés de deux unités ou trois pics de hauteur relative 1/2/1 en cas de présence de deux atomes de brome). | | |

Les spectres IR et ToF-SIMS témoignent très clairement de la présence du groupe bromophényle greffé sur la surface.

### Exemple 13: Greffage de polymères par des groupes carboxyphényles. Solution dans l'acétonitrile

Un échantillon de polymère (PP, PET ou PEEK) est immergé dans une solution de tétrafluoroborate du diazonium de l'acide 4-aminobenzoïque (1,4 g; limite de la solubilité - 0,4 M dans l'acétonitrile (15 mL)) et laissé une heure sous ultrasons ; à la fin de l'irradiation, la température atteint 45°C. Les échantillons sont rincés à l'acétone sous ultrasons 10 minutes, à l'eau distillée sous ultrasons (10 minutes) et enfin dans l'acétonitrile pour analyse sous ultrasons (10 minutes). Les échantillons sont ensuite analysés par IR.

**Tableau 19. Analyse IR d'échantillons greffés par le sel de diazonium de l'acide 4-aminobenzoïque.**

| Echantillon | Bande IR¹⁾ cm⁻¹ | Attribution | Acide 4-aminobenzoique ²⁾ cm⁻¹ |
|---|---|---|---|
| PP | 1687 | C=O | 1658 |
| | 1612 | Vibration du cycle | 1599 |
| PET | 1680³⁾ | C=O | 1658 |
| PEEK | /⁴⁾ | / | |

| | | | |
|---|---|---|---|
| 1)après soustraction du spectre du polymère ; 2)solide ; 3) épaulement sur la bande ester du PET ; 4)les bandes C=O du PEEK et du groupe C₆H₄COOH sont trop proches pour être distinguées. | | | |

Les angles de contact de l'eau ont été mesurés avant et après traitement :

**Tableau 20. Angles de contact d'échantillons greffés par le sel de diazonium de l'acide 4-aminobenzoïque.**

| Echantillon | Angle de contact avant traitement | Angle de contact après traitement |
|---|---|---|
| PP | | 125 |
| | 124 | 82 (après 10')^{b)} |
| | | 82 (après 20') ^{b)} |
| PET | 90 | 75 |
| PEEK | 87 | 55 |

| | | |
|---|---|---|
| b) sans diminution notable de la taille de la goutte. | | |

La présence de bandes C=O et aromatiques en IR ainsi que le caractère plus hydrophile de la surface témoignent du greffage du groupe 4-carboxyphényle.

### Exemple 14: Greffage de polymères par des groupes anthraquinones. Solution dans l'acétonitrile

Trois échantillons de polymères (PP, PET, PEEK) sont introduits dans une solution saturée dans l'acétonitrile (<0,1 M) de Fast Red AL salt dont la formule est donnée ci-dessous. Après une heure sous ultrasons, les échantillons sont rincés à l'eau, à l'acétone, puis 10 minutes sous ultrasons dans l'eau distillée, puis l'acétone, puis l'acétonitrile pour analyse. Ces échantillons sont ensuite examinés par IR.

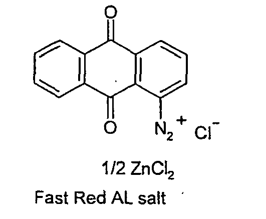

**Tableau 21. Analyse IR d'échantillons greffés par le Fast Red AL salt**

| Echantillon | Bande IR¹⁾ cm⁻¹ | Attribution |
|---|---|---|
| PP | 1749 vw | C=O 1749 pour le Fast Red |
| | ≈1367 vw | 1367 pour le Fast Red |
| | ≈1219 vw | 1219 pour le Fast Red |
| PET | ≈1749 vw | C=O 1749 pour le Fast Red |
| PEEK | 1749 vw | C=O 1749 pour le Fast Red |
| | 1371 vw | 1367 pour le Fast Red |
| | ≈1167vw | 1164 pour le Fast Red |

| | | |
|---|---|---|
| 1) après soustraction du pic du polymère lui-même | | |

Bien que faible, il est dans les trois cas possible d'observer la bande C=O du Fast Red A1 Salt indiquant bien son greffage.

### Exemple 15: Greffage de polymères par des groupes trifluorométhylphényles. Variation du greffage en fonction du temps de réaction.

On prépare 5 tubes contenant chacun un échantillon de PP, de même avec des échantillons de PET et de PEEK. On prépare 45 mL de solution 0,15 M de 4-trifluorométhylebenzènediazonium dans l'acétonitrile qu'on répartit dans les 15 tubes à raison de 3 mL par tube. Les tubes sont immédiatement placés dans la cuve à ultrasons. Trois échantillons (PP, PET, PEEK) sont retirés après 5, 10, 20, 40 et 60 minutes afin d'examiner la variation du taux de greffage en fonction du temps. Les échantillons sont lavés deux fois à l'acétone (10 minutes sous ultrasons) puis à l'acétonitrile (10 minutes sous ultrasons) et séchés sous vide à 40°C.

Les échantillons sont ensuite examinés par spectroscopie IR.

**Tableau 22. Analyse IR d'échantillons greffés par le 4-trifluorométhylphényl benzènediazonium**

| ₂HN-C₆H₄-CF₃ | ⁺₂N-C₆H₄CF₃ BF₄^{-a)} | PP^{c)} | PET | PEEK | Attribution |
|---|---|---|---|---|---|
| 3052 | 3055 | | d) | | Elongation C-H aromatique |
| 1626 | 1636 | | d) | | Vibration du cycle aromatique |
| 1527 | | 1559 | d) | | Vibration du cycle aromatique |
| 1441 | 1426 | 1452 | d) | | Vibration du cycle aromatique |
| 1319 | 1320 | 1340 | | | CF₃ |
| 1185 | 1180 | 1222 | | | CF₃ |
| 1157 | 1138 | 1160 | | | CF₃ |
| 1061 | b) | 1070 | | | CF₃ |
| 829 | 852 | 844 | | | Vibration CH hors du plan 1,4-disubstitution |

| | | | | | |
|---|---|---|---|---|---|
| a) la bande correspondant à la fonction diazonium apparaît à 2307 cm⁻¹. b) Cachées par la grande bande correspondant aux ions BF₄⁻.c) Après soustraction du spectre du polymère lui-même. d) les bandes correspondant aux substituants ne peuvent être distinguées de celles du polymère lui-même. | | | | | |

Les spectres sont en accord avec le greffage des groupes trifluorométhylphényles. Les intensités des bandes -CF₃ en fonction du temps ont été tracées sur les Figures 1, 2 et 3 afin de suivre la cinétique de greffage.

La similitude de la variation de l'intensité des différentes bandes CF₃ indique que la variation observée n'est pas due à un artéfact. La moyenne de la variation de ces intensités atteint une valeur limite après 20 minutes. Cette durée d'irradiation par des ultrasons est donc suffisante pour obtenir le greffage maximal.

### Exemple 16: Greffage dans une solution aqueuse de composés binaires ou ternaires et de diélectriques inorganiques par des groupes trifluorométhylphényles.

Dans cinq tubes à essai contenant respectivement un échantillon de TaN, TiN, SiC, SiOC, SiO₂, on ajoute 260 mg de 4-trifluorométhylbenzènediazonium (concentration finale 0,2 M ; solution saturée) puis 5 mL de H₂SO₄ 0,1N. On laisse une heure sous ultrasons. Les échantillons sont ensuite lavés à l'eau chaude, deux fois 10 minutes à l'eau distillée sous ultrasons, une fois 10 minutes à l'acétone sous ultrasons et on sèche sous vide à 40°C.

**Tableau 23. Analyse ToF-SIMS de composés binaires ou ternaires et de diélectriques inorganiques modifiés par des groupes trifluorométhylphényles**

| Substrat | m/z | Interprétation |
|---|---|---|
| TaN | 69 | CF₃⁻ |
| | 145 | C₆H₄CF₃⁺ |
| | 160 | NHC₆H₄CF₃⁻ |
| TiN | 69 | CF₃⁻ |
| | 145 | C₆H₄CF₃⁻ |
| SiC | 69 | CF₃⁻ |
| | 145 | C₆H₄CF₃^{- et +} |
| | 185 | C-Si-C₆H₄CF₃ |
| | 204 | 185+19 (F)⁻ |
| SiOC | 69 | CF3^{- et +} |
| | 127 | C₆H₄CF₂H⁻ |
| | 145 | C₆H₄CF₃⁻ |
| | 155 | SiCF₂H⁻ |
| SiO₂ | 69 | CF₃⁻ |
| | 145 | C₆H₄CF₃^{- et +} |
| | 173 | Si- C₆H₄CF₃⁺ |
| | 201 | Si-Si- C₆H₄CF₃⁺ |
| | 219 | O- Si-Si- C₆H₄CF₃⁺ +2 |
| | 235 | 219 + 16 (O) |
| | 241 | 235+16(O) |
| | 269 | 241+28 (Si) |

Dans tous les cas on observe les groupes chimiques CF₃ et C₆H₄CF₃ qui signent la modification de la surface.

### Exemple 17: Greffage de Kapton^{®} et de PET en présence de 4-nitrobenzène diazonium dans une solution alcoolique ou dans une solution aqueuse non tamponnée.

Bravo-Diaz et coll. (Costas-Costas, U.; Bravo-Diaz, C.; Gonzalez-Romero, E. *Langmuir* 2004, *20*, 1631) ont montré que la réaction de dédiazonation (c'est-à-dire la perte de la fonction chimique diazonium -N≡N⁺) pouvait se faire de deux manière différentes: soit de manière hétérolytique avec formation d'un cation aryle (Ar⁺), soit de manière homolytique avec formation d'un radical (Ar°) (Pazo-Llorente, R.; Bravo-Diaz, C.; Gonzalez-Romero, E. Eur. J. Org. Chem.. 2004, 3221). Ils ont montré que l'éthanolyse est une manière efficace de former le radical aryle par l'intermédiaire d'un diazo-éther (Ar-N=N-OR). En conséquence, la réaction de dédiazonation homolytique a été effectuée dans l'éthanol par activation sous ultrasons.

Dans un tube à hémolyse contenant un échantillon de Kapton^{®} ou de PET, on introduit 213 mg de 4-nitrobenzène diazonium dans 6 mL d'alcool éthylique (c = 0,1M) et on place dans une cuve à ultrasons pendant 60 minutes. L'échantillon est ensuite rincé dans l'eau distillée (2 fois 10 minutes) sous ultrasons puis séché et de nouveau 10 minutes dans l'acétone sous ultrasons. L'intensité des pics caractéristiques du groupement chimique -NO₂ sont du même ordre de grandeur que lorsque la réaction est effectuée dans l'acétonitrile. On identifie bien par ToF-SIMS les pics caractéristiques du greffon -C₆H₄NO₂ (NO2⁻, C₆H₄NO₂⁺ et diminution de l'intensité des pics du substrat lui-même).

De même, Bunnett (Bunnett, J.F.; Yjima, C. J. Org. Chem. 1977, 42, 639) a montré qu'il était possible d'effectuer une réaction de dédiazonation dans le méthanol basique. Un échantillon de Kapton^{®} a été placé dans une solution 0,1 M de méthanol basique (4% d'hydroxyde de tétraméthylammonium dans le méthanol) qui a été traité comme ci-dessus. Il n'y a pas de différence sensible avec le greffage effectué dans l'acétonitrile, par contre il semble que la surface du polymère soit modifiée par les conditions basiques.

La même réaction a été effectuée dans de l'eau distillée non tamponnée avec la même concentration en diazonium: les pics du groupement chimique -NO₂ sont du même ordre de grandeur que lorsque la réaction est effectuée dans l'acétonitrile.

### Exemple 18: Greffage de ballons utilisés dans la pose de stents artériels afin d'améliorer l'adhésion du stent sur le ballon.

Les stents sont des dispositifs placés à l'intérieur des artères souffrant de sténose (c'est-à-dire partiellement bouchées). Dans ces dispositifs composés d'un cylindre de treillis métallique, on introduit un petit ballon (dégonflé et plié sur lui-même), généralement en polyamide, lui-même fixé au bout d'un long cathéter. Lors de la pose du stent, le cardiologue introduit dans une artère le stent serti (crimped) sur le ballon à l'extrémité du cathéter. Il pousse le dispositif jusqu'à l'emplacement de la sténose, gonfle le ballon qui lui-même dilate le stent. Une fois le stent en place, le ballon est dégonflé et évacué de l'artère par le cathéter. Le stent doit être suffisamment lié au ballon, donc au cathéter, pour ne pas être libéré avant sa mise en place et en même temps la liaison doit être assez faible pour que le ballon se sépare du stent lorsque celui-ci est dégonflé. L'adhésion entre le ballon et le stent a été améliorée en traitant la surface du ballon par des sels de diazonium sous ultrasons.

Pour empêcher les ballons fixés à l'extrémité du cathéter de se déplier, ils sont maintenus sous dépression par aspiration à l'aide d'une seringue fixée à l'autre extrémité du cathéter. Ils sont alors nettoyés dans l'éthanol pendant 10 minutes puis séchés à l'étuve à 40°C pendant deux heures. Ils sont ensuite placés dans une solution (H₂SO₄ 10 mM) du sel de diazonium de l'acide 4-aminobenzoïque (0,15 M) sous ultrasons dans la cuve décrite plus haut pendant une heure. Ils sont ensuite rincés à l'eau distillée (5 minutes) puis à l'acétone (1 minute) sous ultrasons et enfin séchés sous vide à 40°C.

L'analyse des ballons greffés par spectroscopie infrarouge est résumée sur le tableau ci-dessous :

**Tableau 24. Greffage de ballons de stents par des groupes C₆H₄COOH en cm⁻¹.**

| | ₂HNC₆H₄COOH | ⁺₂NC₆H₄COOH | ⁻C₆H₄COOH | ⁻C₆H₄COF* |
|---|---|---|---|---|
| COOH | 3400-2200 | 3242 | 3139 | |
| C=O | 1660 | 1719 | | 1843 |
| CH aromatique (hors du plan) | 841 | 866 | 853 | |
| | 769 | 763 | 777 | |
| | | | 719** | |
| | 698 | 702 | 692 | |

| | | | | |
|---|---|---|---|---|
| * obtenu par traitement du stent modifié par la trifluorotriazine (fluorure cyanurique) - ci-dessous - la position de la bande C=O est caractéristique des fluorures d'acide. ** indique un changement de substitution, c'est-à-dire la formation d'une couche polymère sur la surface. | | | | |

Par ToF-SIMS, il est difficile d'observer la signature du groupe C₆H₄COOH attaché sur la surface du ballon. La fonction acide a donc été transformée en fluorure d'acide par traitement à la 2,4,6-trifluoro 1,3,5-triazine (fluorure cyanurique [675-14-9]). Dans 10 mL d'acétonitrile, on place deux ballons, on ajoute 200 µL de fluorure cyanurique et 300 µL de pyridine ; on laisse 24 heures à température ordinaire, on rince deux fois à l'acétone sous ultrasons et on sèche sous vide. Le spectre IR présente la bande caractéristique des fluorures d'acide (tableau 24) et le spectre ToF-SIMS décrit dans le tableau 25 indique à la fois la présence du groupement C₆H₄COF et son greffage sur la surface du ballon (m/z = 151 et 221). Les fluorures d'acide sont des espèces très réactives, il est possible de former des esters ou des amides (par réaction avec des alcools ou des amines) pour surfonctionnaliser la surface.

**Tableau 25. Spectre ToF-SIMS de groupes chimiques C₆H₄COF greffés sur la surface de ballons.**

| m/z | Attribution |
|---|---|
| 19 | F⁻ |
| 111 | C₆H₄FO⁻ |
| 123 | C₆H₄COF⁺ |
| 143 | C7H5F20⁺ |

Une autre vérification du greffage des sels de diazonium sous ultrasons sur des ballons de stents a été effectuée en greffant, dans les mêmes conditions que ci-dessus, des groupes C₆H₄CF₃ dont la signature est facile à identifier par ToF-SIMS.

**Tableau 26. Spectre ToF-SIMS de groupes chimiques -C₆H₄CF₃ greffés sur la surface de ballons.**

| m/z | Attribution |
|---|---|
| 19 | F⁻ |
| 69 | CF₃⁻ |
| 145 | C₆H₄cF₃⁻ |
| 159 | CH₂C₆H₄CF₃⁺ |
| 160 | NHC₆H₄CF₃⁻ |

Les tests effectués ultérieurement sur ces ballons dont la surface est modifiée par des groupes -C₆H₄COOH indiquent une amélioration notable de l'adhésion du ballon sur le stent.

### Exemple 19: Greffage de groupes benzoylphényle sur du polyamide.

Le greffage de groupes benzoylphényles (-C₆H₄(C=O) C₆H₅) est intéressant puisque le groupe carbonyle sous irradiation UV conduit à un biradical susceptible de réagir avec d'autres molécules et en particulier des polymères (Adenier, A.; Cabet-Deliry, E.; Lalot, T.; Pinson , J.; Podvorica, F. Chem Mat 2002, 14, 4576). Nous avons donc, dans les mêmes conditions que pour les groupes C₆H₄COOH, greffé des groupes benzoylphényles en partant du sel de diazonium de la 4-aminobenzophénone (C₆H₅C(=O)C₆H₄N₂⁺) sur des ballons de stents.

Sur la surface greffée, la bande C=O en spectroscopie infrarouge de la benzophénone (située à 1628 cm⁻¹) est trop proche de celle du polyamide (1636 cm⁻¹) pour pouvoir être distinguée ; par contre, on observe bien les vibrations du cycle aromatique (1586. cm⁻¹) et les vibrations hors du plan des C-H aromatiques (703 cm⁻¹). Le spectre ToF-SIMS de la surface du ballon confirme le greffage.

**Tableau 27. Spectre ToF-SIMS de groupes benzoylphényles greffés sur du polyamide.**

| m/z | Attribution |
|---|---|
| 77 | C₆H₅⁺ |
| 105 | C₆H₅C=O⁺ |
| 119 | CH₃C₆H₄C=O⁺ |
| 133 | CH₃CH₂C₆H₄C=O⁺ |

### Exemple 20: Greffage dans une solution acide aqueuse de Kapton^{®} en présence de 4-nitrobenzène diazonium. Utilisation de cuves à ultrasons de la Société PCT systems.

L'équipement utilisé est un système Megasonics PCT utilisant 3 générateurs couplés à un transducteur plan circulaire de ∼ 350mm de diamètre. Un système de circulation d'eau permet le renouvellement d'une couche de liquide à la surface du transducteur, injectée par une buse centrale. Les paramètres suivants ont été utilisés pour la sonication:
1) Mode d'excitation
   a. Générateur "Mégasonique" conventionnel (monofréquence collimatée)
   b. "Liquid Plasma™" (multifréquence avec propagation multidirectionnelle de l'énergie transmise)
2) Puissance : basse, moyenne ou haute (< 10 W/cm²)
3) Temps de traitement : 10 min
4) Présence d'un ring en céramique sur le transducteur qui augmente le volume de liquide d'eau sur la surface du transducteur même. Ceci devrait augmenter la transmission d'énergie sonique sur les parois du bécher (cf. ci-dessous).

Les échantillons ont été traités en couple (SiO₂+Kapton^{®}) dans un bécher en quartz posé sur le transducteur. 150 ml de solution aqueuse 0,02 M en acide sulfurique contenant le 4-nitrobenzènediazonium (0,15 M) ont été utilisés et renouvelés à chaque couple d'échantillons. Après rinçage, les échantillons ont été analysés par IR et ToF-SIMS. Les spectres montrent clairement la présence de la fonction chimique -NO₂ (en infrarouge à 1363 et 1502 cm⁻¹ pour les vibrations antisymétriques et symétriques de - NO₂ et m/z = 46 en ToF-SIMS correspondant au fragment NO₂⁻). Ces spectres qualitatifs ne permettent pas d'observer de différences importantes selon la méthode de production des ultrasons ou la puissance de l'appareil.

### CONCLUSION

Il a été montré qu'il est possible de fonctionnaliser la surface de polymères et de diélectriques par réaction avec des groupes aryles provenant de sel de diazonium. Les résultats ci-dessus montrent qu'il est possible de greffer une variété de groupements phényles substitués : (-C₆H₄NO₂, -C₆H₄Br, -C₆H₄COOH, -C₆H₄CF₃, anthraquinone). La réalité de ce greffage a pu être mis en évidence par IR, ToF-SIMS et angle de contact.

La réduction de diazonium en solution homogène conduit à des radicaux aryles qui se greffent sur la surface et on observe bien leur présence sur les surfaces étudiées.

Réduction par NaI. On observe dans tous les cas la présence de Br sur les surfaces étudiées. On peut également noter que de l'iode se fixe sur les surfaces étudiées.

Réduction par le férrocèneméthanol. Il a été possible de greffer des groupements bromophényles, à la fois sur des polymères et des diélectriques inorganiques. On observe aussi, dans tous les cas étudiés, du brome sur la surface. Il a été aussi greffé des groupes carboxyphényles qui rendent la surface hydrophile.

Réduction par l'acide hypophosphoreux. Ce réactif fonctionnant en solution aqueuse et d'un coût plus accessible que le ferrocèneméthanol a permis de greffer à la fois sur des polymères organiques et sur des diélectriques inorganiques des groupes iodo, bromo et trifluorophényles.

Photochimie d'un complexe de transfert de charge. Il a été possible d'effectuer le greffage soit en utilisant le 1, 4-diméthoxybenzène comme donneur d'électrons à l'état excité, soit en utilisant les polymères riches en électrons eux-mêmes tels que le PET, le PEEK ou l'ABS. On a ainsi pu greffer des groupes bromo- ou trifluoro- ou carboxyphényles. La réaction est possible soit en solvant organique, soit en solution aqueuse. Les temps de réaction sont courts, ce qui augmente l'intérêt pratique de cette réaction.

Utilisation d'ultrasons. Il a été montré que la réaction permet de greffer des groupes nitro, bromo, carboxyliques, anthraquinones et trifluorométhyles. Les échantillons greffés comprennent aussi bien des polymères organiques que des diélectriques inorganiques. La réaction peut être effectuée soit dans un solvant aprotique tel que l'acétonitrile, soit dans l'eau. Le greffage atteint son maximum après environ 20 minutes d'irradiation.

## Revendications

1. Utilisation d'un sel de diazonium R-N₂⁺ portant un groupe aromatique R, pour le greffage dudit groupe aromatique sur des surfaces isolantes, semi-conductrices, de composés binaires ou ternaires ou de matériaux composites, lesdites surfaces présentant une résistivité supérieure ou égale à 10⁻⁵ Ω.m, et de préférence supérieure ou égale à 10⁻³ Ω.m, ledit sel de diazonium étant présent à une concentration proche de sa limite de solubilité, notamment à une concentration supérieure à 0,05 M, et variant de préférence d'environ 0,5 M à environ 4 M.

2. Utilisation selon la revendication 1, dans laquelle le groupe aromatique greffé provient de la réduction dudit sel de diazonium, notamment
- par l'utilisation d'un réducteur dudit sel de diazonium,
- par l'irradiation photochimique d'un complexe de transfert de charges formé à partir dudit sel de diazonium ou
- par le traitement dudit sel de diazonium par ultrasons.

3. Procédé de modification de la surface d'un matériau isolant, d'un matériau semi-conducteur, d'un composé binaire ou ternaire ou d'un matériau composite, pour obtenir un matériau isolant, un matériau semi-conducteur, un composé binaire ou ternaire ou un matériau composite, dont la surface est modifiée par greffage de groupes aromatiques sur ladite surface, éventuellement substitués par des groupes fonctionnels, dans lequel la nature de la liaison entre la surface et les groupes aromatiques greffés qui la modifient est une liaison de type covalent, et étant notamment telle qu'elle résiste à un lavage par ultrasons,
ledit procédé comprenant la mise en contact de ladite surface avec un sel de diazonium et la réduction dudit sel de diazonium portant ledit groupe aromatique à une concentration proche de sa limite de solubilité, notamment à une concentration supérieure à 0,05 M, et variant de préférence d'environ 0,5 M à environ 4 M, notamment par l'utilisation d'un réducteur, par l'irradiation photochimique d'un complexe de transfert de charges formé à partir dudit sel de diazonium ou par le traitement dudit sel de diazonium par ultrasons, pour obtenir lesdits groupes aromatiques greffés sur ladite surface.

4. Procédé selon la revendication 3, **caractérisé en ce que** la durée de la mise en présence de la surface et du sel de diazonium réduit est inférieure à environ 60 minutes, et notamment dure environ 1 à 60 minutes, et de préférence environ 1 à 10 minutes.

5. Procédé selon la revendication 3 ou 4, **caractérisé en ce que** le sel de diazonium répond à la formule ArN₂⁺ X⁻, dans laquelle Ar représente le groupe aromatique et X représente un anion avantageusement choisi parmi : les halogènes, les sulfates, les phosphates les perchlorates, les tétrafluoroborates, les carboxylates et les hexafluorophosphates.

6. Procédé selon l'une quelconque des revendications 3 à 5, **caractérisé en ce que** le sel de diazonium est:
- soit une diazorésine,
- soit un sel de diazonium choisi parmi: 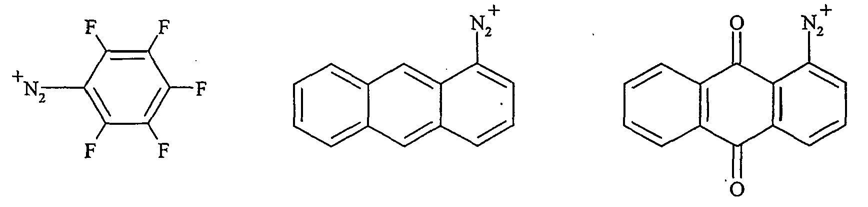 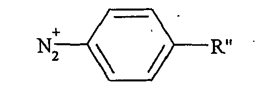 R" étant choisi parmi les groupes suivants : -CH₃, *n-*C₄H₉*, n-*C₁₂H₂₅, -OC₁₂H₂₅, -OC₁₆H₃₃, Cl, -Br, -I, -CH₂Br, -CH(CH₃)Br, -CH₂-O-C(=O)CH(CH₃)Br, -CH₂-O-C(=O)C(CH₃)₂Br, -OH, -CH₂OH, -SH, -CH₂CH₂SH, -CHO, -COCH₃, COOH et 3,4-(COOH)₂, 3-COOH-4-NO₂, 3,4-(C(=O)F)₂, -CH₂COOH, -CH₂CH₂COOH, -COOC₂H₅, -NHC(=O)Ot-Bu, -NHC(=O)CH₃, -NHC(=O)CF₃, CH₂CH₂NH₃⁺, -CN et 3,4-(CN)₂, 3 et 4-NO₂, pyrrolyle, o-hydroxybenzoïque, 2-(2-thiophén-3-yl-acétyl)-aminoéthyl, 4-benzoylbenzène, 4-(2,5-dioxo-2,5-dihydro-pyrrol-1-yl), 3-isonitrile, le 3-dioxo-1H-isochromène-5-diazomuin-3H-benzo[de]chromèn-5-diazonium, 3-(2,5-dioxo-2, 5-dihydro-pyrrol-1-yl) et 4-[1-(2,2,6,6-tétramethyl-pipéridin-1-yloxy)]-éthyle.

7. Procédé selon l'une quelconque des revendications 3 à 6, **caractérisé en ce qu'**il comprend l'utilisation d'un réducteur.

8. Procédé selon la revendication 7, dans lequel le réducteur est choisi parmi:
les réducteurs ayant des potentiels d'oxydation voisins de 0 V/SCE ou négatifs, l'acide hypophosphoreux, les sels d'halogénures, notamment l'iodure de sodium, le ferrocène et ses dérivés, notamment le férrocène-méthanol ou l'acide ferrocène carboxylique, l'acide ascorbique, le diméthylaminoborane, le borohydrure de sodium, les sels de viologène, notamment le méthyl- ou le benzylviologène, et les phénolates, notamment les bisphénolates.

9. Procédé selon la revendication 7 ou 8, **caractérisé en ce qu'**il comprend la mise en contact de la surface avec le sel de diazonium et le réducteur, ledit réducteur étant présent en quantité stoechiométrique ou supérieure à la stoechiométrie par rapport audit sel de diazonium.

10. Procédé selon l'une quelconque des revendications 3 à 6, **caractérisé en ce qu'**il comprend l'irradiation photochimique d'un complexe de transfert de charges formé à partir du sel de diazonium.

11. Procédé selon la revendication 10, comprenant la formation d'un complexe de transfert de charges par la réaction d'un sel de diazonium et d'un composé aromatique donneur d'électrons, et l'irradiation dudit complexe de transfert de charges, pour obtenir la réduction du sel de diazonium et la formation de radicaux aryles qui se lient à ladite surface.

12. Procédé selon la revendication 11, comprenant les étapes suivantes:
- la mise en contact de la surface avec le sel de diazonium et un composé aromatique donneur d'électrons, pour obtenir un complexe de transfert de charges, et
- l'irradiation, notamment par photochimie, dudit complexe de transfert de charges, pour obtenir la réduction du sel de diazonium et la formation de radicaux aryles qui se lient à ladite surface.

13. Procédé selon l'une quelconque des revendications 3 à 6, **caractérisé en ce qu'**il comprend l'utilisation d'ultrasons.

14. Procédé selon la revendication 13, **caractérisé en ce qu'**il comprend une étape de mise en contact de la surface avec le sel de diazonium et de traitement aux ultrasons.

15. Surfaces modifiées d'un matériau isolant de nature organique ou inorganique ou d'un matériau semi-conducteur de nature inorganique ou d'un composé binaire ou ternaire ou d'un matériau composite, obtenues par la mise en oeuvre du procédé selon l'une quelconque des revendications 3 à 14.

## Claims

1. A use of a R-N₂⁺ diazonium salt carrying an aromatic group R, for the grafting of the said aromatic group onto insulating, semiconductor surfaces, of binary or ternary compound or of composite materials, the said surfaces having a resistivity greater than or equal to 10⁻⁵ Ω.m, and preferably higher than or equal to 10⁻³ Ω.m, the said diazonium salt being present at a concentration close to its solubility limit, in particular at a concentration higher than 0,05 M, and preferably varying between about 0,5 M to about 4 M.

2. The use according to claim 1, wherein the grafted aromatic group is obtained from the reduction of the said diazonium salt, in particular
- by the use of a reducer of the said diazonium salt,
- by photochemical irradiation of a charge transfer complex formed from the said diazonium salt or
- by the treatment of the said diazonium salt by ultrasound.

3. A process for modifying the surface of an insulating material, of a semiconductor material, of a binary or ternary compound or of a composite material to obtain an insulating material, a semiconductor material, a binary or ternary compound or a composite material, the surface of which is modified by the grafting of aromatic groups onto the said surface, possibly substituted by functional groups, in which the nature of the bond between the surface and the grafted aromatic groups that modify it is a covalent-type bond, and in particular being such that it resists washing by ultrasound,
the said process comprising contacting the said surface with a diazonium salt and the reduction of the said diazonium salt carrying the said aromatic group at a concentration close to its solubility limit, in particular at a concentration higher than 0,05 M, and preferably varying between about 0,5 M to about 4 M, in particular by the use of a reducer, by photochemical irradiation of a charge transfer complex formed from the said diazonium salt or by the treatment of the said diazonium salt by ultrasound, to obtain said grafted aromatic groups on the said surface.

4. The process according to claim 3, **characterised in that** the period of placing the surface in the presence of the reduced diazonium salt is less than about 60 minutes, and in particular lasts about 1 to 60 minutes, and preferably about 1 to 10 minutes.

5. The process according to claim 3 or claim 4, **characterised in that** the diazonium salt has the formula ArN₂⁺ X, wherein Ar represents the aromatic group and X represents an anion advantageously selected from: halogens, sulphates, phosphates, perchlorates, tetrafluoroborates, carboxylates and hexafluorophosphates.

6. The process according to any one of claim 3 to claim 5, **characterised in that** the diazonium salt is :
- either a diazoresine,
- or a diazonium salt chosen from: 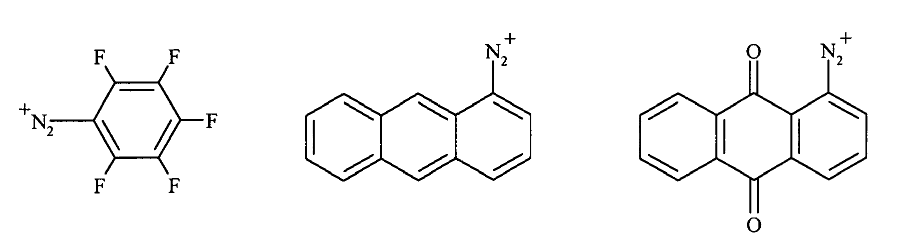 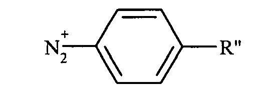 R" being chosen from the following groups: -CH₃, *n*-C₄H₉, *n*-C₁₂H₂₅, -OC₁₂H₂₅, -OC₁₆H₃₃, Cl, -Br, -I, -CH₂Br, -CH(CH₃)Br, -CH₂-O-C(=O)CH(CH₃)Br, -CH₂-O-C(=O)C(CH₃)₂Br, -OH, -CH₂OH, -SH, -CH₂CH₂SH, -CHO, -COCH₃, COOH and 3,4-(COOH)₂, 3-COOH-4-NO₂, 3,4-(C(=O)F)₂, -CH₂COOH, -CH₂CH₂COOH, -COOC₂H₅, -NHC(=O)Ot-Bu, -NHC(=O)CH₃, -NHC(=O)CF₃, CH₂CH₂NH₃+, -CN and 3,4-(CN)₂, 3 and 4-NO₂, pyrrolyl, o-hydroxybenzoic, 2-(2-thiophen-3-yl-acetyl)-aminoethyl, 4-benzoylbenzene, 4-(2,5-dioxo-2,5-dihydro-pyrrol-1-yl), 3-isonitrile, 3-dioxo-1H-isochromene-5-diazonium-3H-benzo[de]chromene-5-diazonium, 3-(2,5-dioxo-2, 5-dihydro-pyrrol-1-yl) and 4-[1-(2,2,6,6-tetramethyl-piperidine-1-yloxy)]-ethyl.

7. The process according to any one of claim 3 to claim 6, **characterised in that** it includes the use of a reducer.

8. The process according to claim 7, in which the reducer is chosen from:
reducers having oxidation potentials close to 0 V/SCE or negative, hypophosphorous acid, halide salts, in particular sodium iodide, ferrocene and its derivatives, in particular ferrocene-methanol or carboxylic ferrocene acid, ascorbic acid, dimethylaminoborane, sodium borohydride, viologene salts, in particular methyl- or benzoviologene and phenolates, in particular bisphenolates.

9. The process according to claim 7 or claim 8, **characterised in that** it includes contacting the surface with the diazonium salt and the reducer, the said reducer being present in stoechiometric quantity or greater than stoechiometry relative to the said diazonium salt.

10. The process according to anyone of claim 3 to claim 6, **characterised in that** it comprises the photochemical irradiation of a charge transfer complex formed from the diazonium salt.

11. The process according to claim 10, comprising the formation of a charge transfer complex by reacting diazonium salt and an electron-donor aromatic compound, and irradiation of the said charge transfer complex, to obtain the reduction of the diazonium salt and the formation of aryl radicals which bond to the said surface.

12. The process according to claim 11, comprising the following stages:
- contacting the surface with the diazonium salt and an electron-donor aromatic compound, to obtain a charge transfer complex, and
- irradiation, in particular by photochemistry, of the said charge transfer complex, to obtain the reduction of the diazonium salt and the formation of aryl radicals which bind to the said surface.

13. The process according to any one of claim 3 to claim 6, **characterised in that** it includes the use of ultrasound.

14. The process according to claim 13, **characterised in that** it includes a stage of contacting the surface with diazonium salt and of treatment with ultrasound.

15. Modified surfaces of an organic or inorganic insulating material or an inorganic semiconductor material or a binary or ternary compound or composite material, obtained by use of the process according to any one of claim 3 to claim 14.

## Patentansprüche

1. Verwendung eines Diazoniumsalzes R-N₂⁺, das eine aromatische Gruppe R trägt, zum Pfropfen der aromatischen Gruppe auf die isolierenden, halbleitenden Oberflächen von binäreren oder ternären Verbindungen oder von Verbundmaterialien, wobei die Oberflächen einen spezifischen Widerstand größer oder gleich 10⁻⁵ Ω.m und bevorzugt größer oder gleich 10⁻³ Ω.m aufweisen, wobei das Diazoniumsalz in einer Konzentration nahe an dessen Löslichkeitsgrenze, insbesondere in einer Konzentration von mehr als 0,05 M und bevorzugt zwischen etwa 0,5 M und etwa 4 M variierend, vorhanden ist.

2. Verwendung nach Anspruch 1, wobei die gepfropfte aromatische Gruppe aus der Reduktion des Diazoniumsalzes stammt, insbesondere
- durch Verwendung eines Diazoniumsalzreduktionsmittels,
- durch photochemische Bestrahlung eines Ladungsübertragungskomplexes, der aus dem Diazoniumsalz gebildet wurde, oder
- durch Ultraschallbehandlung des Diazoniumsalzes.

3. Verfahren zur Veränderung der Oberfläche eines isolierendes Materials, eines halbleitendes Materials, einer binären oder ternären Verbindung oder eines Verbundmaterials, um ein isolierendes Material, ein halbleitendes Material, eine binäre oder ternäre Verbindung oder ein Verbundmaterial zu erhalten, deren Oberfläche durch Pfropfen von aromatischen Gruppen, die gegebenenfalls mit funktionellen Gruppen substituiert sind, auf die Oberfläche modifiziert ist, wobei die Art der Verbindung zwischen der Oberfläche und den gepfropften aromatischen Gruppen, die sie modifizieren, eine Verbindung kovalenten Typs ist, die im Wesentlichen derart ist, dass sie gegen eine Ultraschallwäsche beständig,
wobei das Verfahren das Inkontaktbringen der Oberfläche mit einem Diazoniumsalz und die Reduktion des Diazoniumsalzes, das die aromatische Gruppe in einer Konzentration nahe dessen Löslichkeitsgrenze, insbesondere in einer Konzentration von mehr als 0,05 M, und bevorzugt zwischen etwa 0,5 M und etwa 4 M variierend, trägt, insbesondere durch die Verwendung eines Reduktionsmittels, durch photochemische Bestrahlung eines Ladungsübertragungskomplexes, der aus dem Diazoniumsalz gebildet wurde, oder durch die Ultraschallbehandlung des Diazoniumsalzes umfasst, um die gepfropften aromatischen Gruppen auf der Oberfläche zu erhalten.

4. Verfahren nach Anspruch 3, **dadurch gekennzeichnet, dass** die Dauer des Zusammenbringens der Oberfläche und des reduzierten Diazoniumsalzes weniger als etwa 60 Minuten beträgt, und insbesondere etwa 1 bis 60 Minuten und bevorzugt etwa 1 bis 10 Minuten dauert.

5. Verfahren nach Anspruch 3 oder 4, **dadurch gekennzeichnet, dass** das Diazoniumsalz der Formel ArN₂⁺X⁻entspricht, worin Ar für die aromatische Gruppe steht und X für ein Anion steht, das vorteilhafterweise ausgewählt ist aus: Halogenen, Sulfaten, Phosphaten, Perchloraten, Tetrafluorboraten, Carboxylaten und Hexafluorphosphaten.

6. Verfahren nach einem der Ansprüche 3 bis 5, **dadurch gekennzeichnet, dass** das Diazoniumsalz:
- entweder ein Diazoharz,
- oder ein Diazoniumsalz ist, ausgewählt aus: 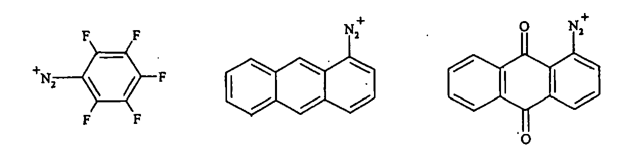 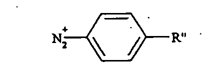 worin R" ausgewählt ist aus den folgenden Gruppen: - CH₃, *n*-C₄H₉, *n*-C₁₂H₂₅, -OC₁₂H₂₅, -OC₁₆H₃₃, Cl, -Br, -I, - CH₂Br, -CH(CH₃)Br, -CH₂-O-C(=O)CH(CH₃)Br, -CH₂-O-C(=O)C(CH₃)₂Br, -OH, -CH₂OH, -SH, -CH₂CH₂SH, -CHO, - COCH₃, COOH und 3,4-(COOH)₂, 3-COOH-4-NO₂, 3,4-(C(=O)F)₂, -CH₂OOOH, -CH₂CH₂OOOH, -COOC₂H₅, -NHC(=O)Ot-Bu, -NHC(=O)CH₃, -NHC(=O)CF₃, CH₂CH₂NH₃⁺, -CN und 3,4-(CN)₂, 3 und 4-NO₂, Pyrrolyl, o-Hydroxybenzoesäure, 2-(2-Thiophen-3-yl-acetyl)-aminoethyl, 4-Benzoylbenzol, 4-(2,5-Dioxo-2,5-dihydro-pyrrol-1-yl), 3-Isonitril, 3-Dioxo-1H-isochromen-5-diazonium-3H-benzo[de]chromen-5-diazonium, 3-(2,5-Dioxo-2,5-dihydro-pyrrol-1-yl) und 4-[1-(2,2,6,6-Tetramethyl-piperidin-1-yloxy)]-ethyl.

7. Verfahren nach einem der Ansprüche 3 bis 6, **dadurch gekennzeichnet, dass** es die Verwendung eines Reduktionsmittels umfasst.

8. Verfahren nach Anspruch 7, wobei das Reduktionsmittel ausgewählt ist aus: Reduktionsmitteln, die Oxidationspotentiale nahe an 0 V/SCE oder negative Oxidationspotentiale aufweisen, Hypophosphorsäure, Halogenidsalze, insbesondere Natriumiodid, Ferrocen und dessen Derivate, insbesondere Ferrocenmethanol oder Ferrocencarbonsäure, Ascorbinsäure, Dimethylaminoboran, Natriumborhydrid, Viologensalze, insbesondere Methyl- oder Benzylviologen und Phenolate, insbesondere Bisphenolate.

9. Verfahren nach Anspruch 7 oder 8, **dadurch gekennzeichnet, dass** es das Inkontaktbringen der Oberfläche mit dem Diazoniumsalz und dem Reduktionsmittel umfasst, wobei das Reduktionsmittel, bezogen auf das Diazoniumsalz, in stöchiometrischer Menge oder überstöchiometrisch vorhanden ist.

10. Verfahren nach einem der Ansprüche 3 bis 6, **dadurch gekennzeichnet, dass** es die photochemische Bestrahlung eines Ladungsübertragungskomplexes umfasst, der aus dem Diazoniumsalz gebildet wurde.

11. Verfahren nach Anspruch 10, das die Bildung eines Ladungsübergangskomplexes durch die Umsetzung eines Diazoniumsalzes mit einer elektronengebenden aromatischen Verbindung und die Bestrahlung des Ladungsübertragungskomplexes umfasst, um die Reduktion des Diazoniumsalzes und die Bildung von Arylradikalen zu erhalten, die sich mit der Oberfläche verbinden.

12. Verfahren nach Anspruch 11, das die folgenden Schritte umfasst:
- Inkontaktbringen der Oberfläche mit dem Diazoniumsalz und einer elektronengebenden aromatischen Verbindung, um einen Ladungsübertragungskomplex zu erhalten, und
- Bestrahlen, insbesondere mittels Photochemie, des Ladungsübertragungskomplexes, um die Reduktion des Diazoniumsalzes und die Bildung von Arylradikalen zu erhalten, die sich mit der Oberfläche verbinden.

13. Verfahren nach einem der Ansprüche 3 bis 6, **dadurch gekennzeichnet, dass** es die Verwendung von Ultraschall umfasst.

14. Verfahren nach Anspruch 13, **dadurch gekennzeichnet, dass** es einen Schritt zum Inkontaktbringen der Oberfläche mit dem Diazoniumsalz und zur Ultraschallbehandlung umfasst.

15. Modifizierte Oberflächen eines isolierenden Materials organischer oder anorganischer Art oder eines halbleitenden Materials anorganischer Art oder einer binären oder ternären Metallverbindung oder eines Verbundmaterials, die durch die Durchführung des Verfahrens nach einem der Ansprüche 3 bis 14 erhalten wurden.
